(19) Europäisches Patentamt
European Patent Office
Office européen des brevets

(11) **EP 2 022 045 B1**

(12) **EUROPEAN PATENT SPECIFICATION**

(45) Date of publication and mention
of the grant of the patent:
**27.02.2013 Bulletin 2013/09**

(21) Application number: **07734657.5**

(22) Date of filing: **24.05.2007**

(51) Int Cl.:
***G10L 19/04*** (2013.01)

(86) International application number:
**PCT/IB2007/001351**

(87) International publication number:
**WO 2007/138419 (06.12.2007 Gazette 2007/49)**

(54) **DECODING OF PREDICTIVELY CODED DATA USING BUFFER ADAPTATION**

DEKODIERUNG PRÄDIKTIV KODIERTER DATEN ÜBER PUFFERANPASSUNG

DÉCODAGE DE DONNÉES CODÉES PRÉDICTIVEMENT AU MOYEN D'UNE ADAPTATION DE TAMPONS

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **01.06.2006 US 421541**

(43) Date of publication of application:
**11.02.2009 Bulletin 2009/07**

(73) Proprietor: **Nokia Corporation**
**02150 Espoo (FI)**

(72) Inventor: **OJANPERA, Juha**
**37120 Nokia (FI)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(56) References cited:
**EP-A1- 1 255 244**    **EP-A2- 1 249 837**
**WO-A1-01/03122**    **CA-A1- 2 586 251**
**US-A1- 2005 252 361**    **US-B1- 6 208 276**

• **HERRE J ET AL: "Overview of MPEG-4 audio and its applications in mobile communications" 2000 INTERNATIONAL CONFERENCE ON COMMUNICATION TECHNOLOGY PROCEEDINGS : AUGUST 21 - 25, 2000, BEIJING, CHINA ; [PART OF] WCC 2000, [16TH WORLD COMPUTER CONGRESS 2000], PISCATAWAY, NJ, USA,IEEE, US, vol. 1, 21 August 2000 (2000-08-21), pages 604-613, XP010526820 ISBN: 978-0-7803-6394-6**
• **JUHA OJANPERÄ ET AL: "Long Term Predictor for Transform Domain Perceptual Audio Coding" AES CONVENTION 107,, no. 5036, 24 September 1999 (1999-09-24), pages 1-10, XP002493942**
• **'3rd Generation Partnership Project; Technical Specification Group Services and System Aspects; General Audio Codec audio processing functions; Enhanced aacPlus general audio codec; Additional decoder tools, Release 6' 3GPP TS 26.402; V6.1.0, [Online] September 2005, XP003019463 Retrieved from the Internet: <URL: http://www.3gpp.org/ftp/Specs/html-inf o/ 26402.htm>**

**Description**

FIELD OF THE INVENTION

The invention generally relates to decoding of compressed digital information. In particular, at least some embodiments of this invention relate to decoding of bit streams representing content that has been compressed using one or more techniques that employ long-term predictive coding.

BACKGROUND OF THE INVENTION

In order to minimize the amount of data that must be stored and/or transmitted across a communication channel, content (e.g., audio and/or video information) is often compressed into a data stream with fewer bits than might otherwise be needed. Numerous methods for such compression have been developed. Some of those methods employ predictive coding techniques. For example, the Advanced Audio Coding (AAC) format specified by various Motion Picture Experts Group (MPEG) standards includes several sets of tools for coding (and subsequently decoding) audio content (e.g., music). Those tools, or profiles, include the Main, LC (Low Complexity), SSR (Scalable Sampling Rate) and LTP (Long-Term Prediction) profiles. LTP encoding can provide higher quality audio to the end-user, but at a price of increased computational requirements. This can result in a need for additional memory and processing hardware in a device such as a mobile phone or digital music player. Moreover, commercial necessity can require that devices intended to decode and play AAC audio data be able to accommodate multiple profiles. For example, users frequently wish to download music from a variety of sources. Some of those sources may encode music using the AAC-LC profile, while others may encode music using the AAC-LTP profile.

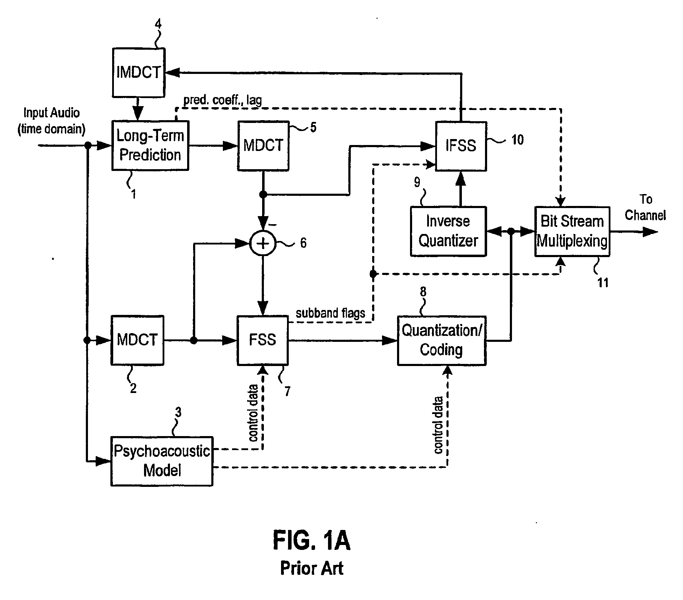

FIG. 1A is a block diagram showing a general structure for an AAC-LTP encoder. Although the operation of such encoders (and some corresponding decoders) is well known, the following overview is included to provide context for subsequent description. An incoming time domain audio signal is received by a long-term predictor 1, a modified discrete cosine transform (MDCT) 2, and by a psychoacoustic model 3. Long-term predictor 1 generates data (prediction coefficients and a pitch lag) that can be used to predict the currently input time-domain signal based on time domain signals for earlier portions of the audio stream. Time domain versions of those earlier portions are received as inputs from inverse modified discrete cosine transform (IMDCT) 4 and from a synthesis filter bank (not shown), and are stored by the long-term predictor in a buffer (also not shown in FIG. 1A). The prediction coefficients and pitch lag are provided by long-term predictor 1 to bit stream multiplexer 11. The predicted audio (i.e., the time domain audio signal that would result from the calculated prediction coefficients and pitch lag) is converted to the frequency domain by MDCT 5.

The incoming time domain audio is also provided to a separate MDCT 2. Unlike MDCT 5, which only transforms the predicted version of that audio, the original incoming audio signal is converted to the frequency domain by MDCT 2. The output from MDCT 2 is provided to a frequency selective switch (FSS) 7 (discussed below) and to a summer 6. Summer 6 computes a difference between the output of MDCT 5 (the frequency domain version of the predicted audio signal) and the output of MDCT 2 (the frequency domain version of the original audio signal). In effect, the output from summer 6 (or prediction error) is the difference between the actual audio signal and the predicted version of that same signal. The prediction error output from summer 6 is provided to FSS 7.

FSS 7 receives control inputs from psychoacoustic model 3. Psychoacoustic model 3 contains experimentally-derived perceptual data regarding frequency ranges that are perceptible to human listeners. Psychoacoustic model 3 further contains data regarding certain types of audio patterns that are not well modeled using long-term prediction. For example, fast changing or transient signal segments can be difficult to model by prediction. Psychoacoustic model 3 examines the incoming audio signal in the time domain and evaluates which sub-bands should be represented by prediction error (from summer 6), prediction coefficients (from predictor 1) and pitch lag (also from predictor 1), as well as which sub-bands should be represented by MDCT coefficients of the original audio (from MDCT 2). Based on data from psychoacoustic model 3, FSS 7 selects data to be forwarded to block 8 for quantization and coding. For sub-bands where prediction is to be used, the prediction error coefficients from summer 6 are forwarded to quantizer/coder 8. For other sub-bands, the MDCT 2 output is forwarded to quantizer/coder 8. A control signal output from FSS 7 includes a flag for each sub-band indicating whether long-term prediction is enabled for that sub-band.

The signals from FSS 7 are then quantized in quantizer/encoder 8 (e.g., using Huffman coding). Perceptual data from psychoacoustic model 3 is also used by quantizer/encoder 8. The output from quantizer/encoder 8 is then multiplexed in block 11 with control data from long-term predictor 1 (e.g., prediction coefficients and pitch lag) and FSS 7 (sub-band flags). From block 11 the multiplexed data is then provided to a communication channel (e.g., a radio or internet transmission) or storage medium. The output from quantizer/coder 8 is also provided to inverse quantizer 9. The output of inverse quantizer 9 is forwarded to inverse frequency selective switch (IFSS) 10, as is the output from MDCT 5 and control signals (sub-band flags) from FSS 7. IFSS 10 then provides, as to each sub-band for which quantized prediction error coefficients were transmitted on the bit stream, the sum of the de-quantized prediction error coefficients and the output from MDCT 5. As to each sub-band for which the quantized MDCT 2 output was transmitted on the bit stream, IFSS provides the dequantized MDCT 2 output. The output from IFSS is then converted back to the time domain by IMDCT 4. The time domain output from IMDCT 4 is then provided to long-term predictor 1. A portion of the IMDCT 4 output is stored directly in the prediction buffer described above; other portions of that buffer hold fully-reconstructed (time domain) audio data frames generated by overlap-add (in the synthesis filter bank) of output from IMDCT 4.

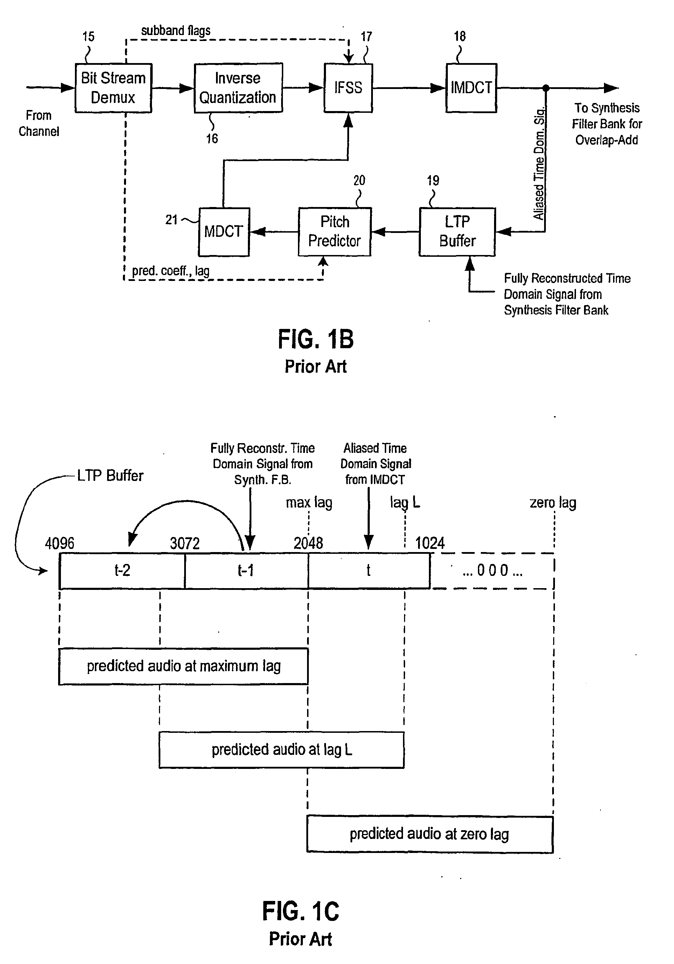

FIG. 1B is a block diagram showing a general structure for an AAC-LTP decoder. The incoming bit stream is demultiplexed in block 15. The sub-band flags from FSS 7 (FIG. 1A) are provided to IFSS 17. The prediction coefficients and pitch lag from long-term predictor 1 in FIG. 1A are provided to pitch predictor 20. The quantized data from FSS 7 in FIG. 1A is dequantized in inverse quantizer 16, and then provided to IFSS 17. Based on the corresponding sub-band flag values, IFSS 17 determines whether long-term prediction was enabled for various sub-bands. For sub-bands where prediction was not enabled, IFSS 17 simply forwards the output of inverse quantizer 16 to IMDCT 18. For sub-bands where prediction was enabled, IFSS 17 adds the output of inverse quantizer 16 (i.e., the dequantized the prediction error coefficients) to the output of MDCT 21 (discussed below), and forwards the result to IMDCT 18. IMDCT 18 then transforms the output of IFSS 17 back to the time domain. The output of IMDCT 18 is then used for overlap-add in a synthesis filter bank (not shown) to yield a fully-reconstructed time domain signal that is a close replica of the original audio signal input in FIG. 1A. This fully-reconstructed time domain signal can then be processed by a digital to analog converter (not shown in FIG. 1B) for playback on, e.g., one or more speakers.

Recent portions of the time domain output from IMDCT 18 and of the fully reconstructed time domain signal from the synthesis filter bank are also stored in long-term prediction (LTP) buffer 19. LTP buffer 19 has the same dimensions as, and is intended to replicate the contents of, the buffer within the long-term predictor 1 of FIG. 1A. Data from LTP buffer 19 is used by pitch predictor 20 (in conjunction with prediction coefficients and pitch lag values) to predict the incoming audio signal in the time domain. The output of pitch predictor 20 corresponds to the output of long-term predictor 1 provided to MDCT 5 in FIG 1A. The output from pitch predictor 20 is then converted to the frequency domain in MDCT 21, with the output of MDCT 21 provided to IFSS 17.

The conventional structure of LTP buffer 19 (as prescribed by the applicable MPEG-4 standards) is shown in FIG. 1C. Frame t-1 is the most recent fully-reconstructed time domain signal formed by overlap-add of time domain signals in the synthesis filter bank (not shown) of the decoder. Frame t is the time domain signal output from IMDCT 18, and is the aliased time domain signal to be used for overlap-add in the next frame to be output by the synthesis filter bank. Frame t-2 is the fully-reconstructed frame from a previous time period. The dimension (or length) N of each frame is 1024 samples. The broken line block on the right side of the LTP buffer represents a frame of 1024 zero-amplitude samples. This all-zero block is not an actual part of LTP buffer 19. Instead, it is used to conceptually indicate the location of the zero lag point. Specifically, when the value for pitch lag is at its maximum, 2048 time domain samples are predicted based on the 2048 samples in frames t-1 and t-2. When the pitch lag is between the minimum and maximum (e.g., at the point indicated as lag L), the 2048 samples prior to the pitch lag location (i.e., to the right of point L in FIG. 1C) are used to predict 2048 samples. When pitch lag is less that 1024, zeros are used for "samples" 1023 and below from the LTP buffer. For example, when the pitch lag is at its minimum (zero lag), the 1024 samples in the t frame and 1024 zero amplitude samples are used to predict 2048 samples. Although the use of the all-zero amplitudes results in less accurate sound reproduction, less memory is needed for the LTP buffer. Because zero or very low lag values occur relatively infrequently, overall sound quality is not seriously affected.

A decoder such as in FIG. 1B and the associated LTP buffer of FIG. 1C are often used in a mobile device such as a portable music player or mobile terminal. Such devices frequently have limited computational and memory resources. Adding additional memory and processing capacity is often expensive, thereby increasing overall cost of the device. Because a decoder and buffer use significant amounts of those resources, there may be limited excess capacity to accommodate additional features. For example, it is often desirable for audio playback devices to have a fast forward capability. If the output rate of the audio decoder is increased, numerous decoding operations must be performed at an even higher rate. As another example, a device that is decoding and playing an audio stream may need to briefly perform some other task (e.g., respond to an incoming telephone call or other communication). Unless processing and memory capacity is increased, or unless the processing and memory needed for audio decoding and playback can be reduced, the device may be unable to simultaneously perform multiple tasks.

As an example, EP 1 249 837-A2 describes a fast forward playback implementation in advanced audio coding (AAC) of the MPEG-4 system.

SUMMARY OF THE INVENTION

A method, a computer program and an apparatus are provided as set forth in independent claims 1, 7 and 14, respectively. Preferred embodiments are set forth in dependent claims.

**EP 2 022 045 B1**

BRIEF DESCRIPTION OF THE DRAWINGS

The foregoing summary of the invention, as well as the following detailed description of illustrative embodiments, is better understood when read in conjunction with the accompanying drawings, which are included by way of example, and not by way of limitation with regard to the claimed invention.

FIG. 1A is a block diagram showing a general structure for a conventional AAC-LTP encoder.

FIG. 1B is a block diagram showing a general structure for a conventional AAC-LTP decoder.

FIG. 1C is a block diagram for a conventional LTP buffer in the decoder of FIG. 1B.

FIG. 2 is a block diagram of one example of a system in which embodiments of the invention can be employed.

FIG. 3 is a block diagram showing one example of a mobile device configured to receive and decode audio signals according to at least some embodiments.

FIG. 4 is a block diagram of a decoder, according to at least some embodiments, adapted to accommodate downsampling.

FIG. 5 shows the LTP buffer from the decoder of FIG. 4 when the decimation factor is 2.

FIGS. 6A-6D show calculation of an array $X_{LTP}p$ [] from the LTP buffer of FIG. 5 under various circumstances.

FIGS. 7A and 7B are flow charts showing operation of the decoder of FIG. 4 according to at least some embodiments.

FIGS. 8A and 8B show how an LTP buffer is adapted, in at least some embodiments, to adjust for upsampling.

FIGS. 9A and 9B are flow charts showing operation of a decoder, according to at least some embodiments, when upsampling is taking place.

FIG. 10 is block diagram of a decoder, according to at least some embodiments, adapted to accommodate upsampling.

FIG. 11 is block diagram of a decoder, according to at least some embodiments, adapted to accommodate both upsampling and downsampling.

DETAILED DESCRIPTION OF THE PREFERRED EMBODIMENTS

Although embodiments of the invention will be described by example of communications in accordance with the Advanced Audio Coding (AAC) format and the Long-Term Prediction (LTP) profile thereof, as defined by the Motion Picture Experts Group MPEG-4 standard (ISO-14496), the invention is not limited in this regard. In particular, the invention is also applicable to other coding schemes in which a coded data stream has been generated using predictive coding methods.

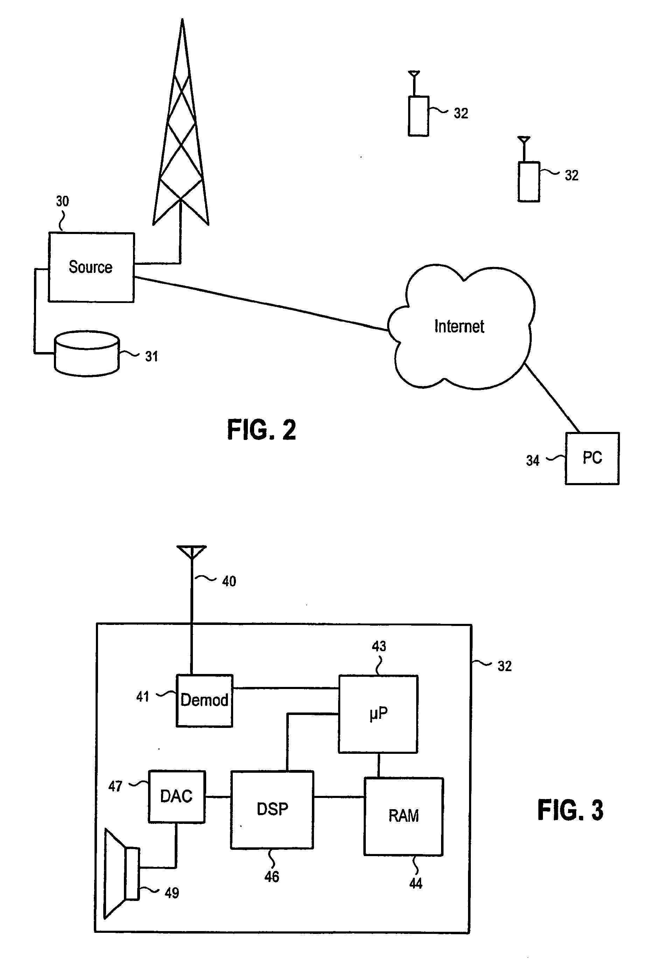

FIG. 2 is a block diagram of one example of a system in which embodiments of the invention can be employed. Source 30 outputs AAC-LTP compressed audio signals for transmission to remote users. Source 30 may produce that AAC-LTP output by real time processing of an input audio signal (not shown), or by accessing previously compressed audio that has been stored in database 31. Source 30 transmits AAC-LTP audio wirelessly to mobile devices 32 (e.g., mobile telephones configured to receive and decode compressed audio signals from source 30). Mobile devices 32 may be communicating within a long-range wireless network (e.g., a mobile telephone network, a 3GPP network, etc.), may be communicating in a short range wireless network (e.g., a BLUETOOTH network), may be communicating via a wireless internet link, may be receiving broadcast transmissions (e.g., satellite radio), etc. Source 30 also provides compressed AAC-LTP over a wired network (e.g., a wired internet connection) for download by devices such as personal computer 34.

FIG. 3 is a block diagram showing one example of a mobile device 32 configured to receive and decode AAC-LTP audio signals according to at least some embodiments. Wireless transmissions from source 30 are received via antenna 40. The incoming radio signal is demodulated and otherwise processed in block 41 to so as to recover the transmitted digital data bit stream. Controller 43 (e.g., a microprocessor) receives the recovered digital signal from block 41. Controller 43 separates the control signals (e.g., prediction coefficients and pitch lag, sub-band flags) from the quantized frequency domain components corresponding to the output from an FSS in source 30 similar to FSS 7 of FIG. 1A. Controller 43 dequantizes those frequency domain components and provides those components (with the control signals) to a digital signal processor (DSP) 46. DSP 46 then uses that data, in a manner discussed below, to generate a time domain signal. The time domain signal from DSP 46 is provided to a digital to analog converter (DAC) 47 and output via a speaker 49. Random access memory 44 is used to store instructions for operation of controller 43 and 46, as well as for data buffering (e.g., for use as an LTP buffer). Read-only memory (ROM) may also be used to store programming instructions for controller 43 and/or DSP 46.

The configuration of FIG. 3 is merely one example. In other embodiments, a separate DSP may not be included, with all processing performed by a single processor. Separate RAM may also be omitted, with a controller and/or DSP instead having internal RAM. Controller 43, DSP 46 and RAM 44 will typically be in the form of one or more integrated circuits ("chips" or a "chip set").

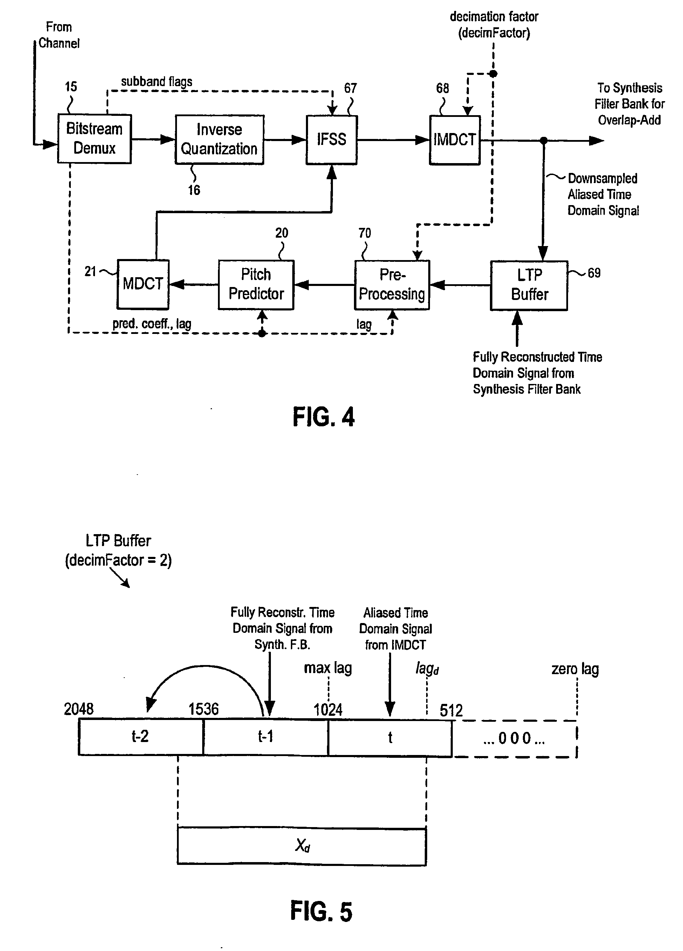

FIG. 4 is a block diagram of a decoder according to at least some embodiments of the invention, and which decodes a signal from a conventional coder such as that shown in FIG. 1A. In some embodiments, operations represented by the blocks 67, 68, 70, 20 and 21 of FIG. 4 (as well as a synthesis filter bank and other elements not shown in FIG. 4) are implemented by performance of programming instructions by DSP 46, with block 69 (LTP buffer) implemented in separate RAM 44. As indicated above, however, one or more of blocks 67, 68, 70, 20 and 21 (and/or other elements) can alternately be implemented by execution of programming instructions in controller 43. Similarly, RAM 69 could be included within DSP 46 and/or controller 43 instead of separate RAM 44.

Bit stream demultiplexer 15, inverse quantizer 16, pitch predictor 20 and MDCT 21 operate similar to like-numbered components in FIG. 1B. IFSS 67 is capable of performing the functions of IFSS 17 in FIG. 1B, but is also able to perform additional operations as described below. IMDCT 68 is capable of functioning in a manner similar to IMDCT 18 of FIG. 1B. However, IMDCT 68 is further configured, in response to an input decimation factor (decimFactor), to perform downsampling with regard to the output audio. Specifically, IMDCT 68 reduces by decimFactor the number of MDCT coefficients that are processed when converting a frequency domain signal back to the time domain. When downsampling is performed, the number of samples in the frames stored in LTP buffer 69 is also affected. When decimFactor = 2, for example, each frame in LTP buffer 69 is only 512 samples in length (vs. 1024 samples in conventional LTP buffers). Although downsampling reduces the number of computations performed in IMDCT 68 and reduces the amount of memory needed for the LTP buffer, a separate problem is introduced. In particular, a downsampled LTP buffer will not match the buffer of the long-term predictor in the AAC-LTP coder that originally produced the coded signal. Unless additional steps are taken, an audio signal subcomponent based on the contents of LTP buffer 69 will not match the corresponding audio signal subcomponent predicted in the coder.

FIG. 5 shows LTP buffer 69 when decimfactor = 2. In a manner similar to the conventional LTP buffer of FIG. 1C, the t frame is filled with aliased time domain signal outputs from IMDCT 68, with frame t-I filled from the most recent fully-reconstructed time domain frame output by the synthesis filter bank. Because of downsampling, and as indicated above, the frames of LTP buffer 69 are shorter than the frames in the coder LTP buffer. In order to adapt to this mismatch, a portion $X_d$ of LTP buffer 69 is first identified in at least some embodiments. Specifically, an offset value $(lag_d)$ is computed based on the pitch lag value transmitted from the coder. $X_d$ is then populated with the contents of LTP buffer 69 starting at $lag_d$ and proceeding back in time (to the left in FIG. 5) for two frame lengths of the current LTP buffer 69 (1024 samples in the example of FIG. 5). The samples of $X_d$ are then expanded by preprocessor 70, in a manner described below, so as to more closely match the LTP buffer in the coder.

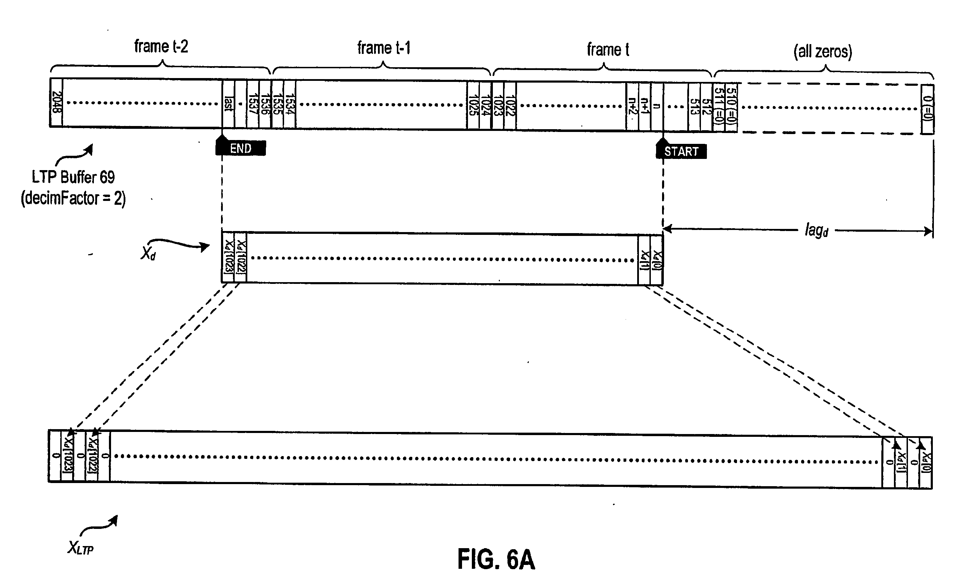

FIG. 6A shows LTP buffer 69 and data array $X_d$ in more detail. The starting point for $X_d$ is identified using $lag_d$; the end point for $X_d$ is identified based on the current decimation factor (decimFactor). The calculation of $lag_d$ is described below. In at least some embodiments, $X_d$ is implemented as an array having 1024/decimFactor elements (i.e., $X_d$ [0, 1, 2, ... (1024/decimfactor-1)]). Array element $X_d$ [0] is filled with the sample in LTP buffer 69 after the start point (sample n in FIG. 6A), $X_d$ [1] filled with the next sample (n+1), etc., with $X_d$ [1023] filled with the sample "last." $X_d$ [ ] is then expanded into an array $X_{LTP}$ [ ] that has the same number of samples used by the long-term predictor in the coder (e.g., 1024 samples). So that $X_{LTP}$ [ ] will more closely resemble the samples used for prediction by the long-term predictor within the coder, the contents of $_Xd$ [ ] are evenly distributed throughout $X_{LTP}$ [ ], with values of zero inserted for intervening sample slots in $X_{LTP}$ [ ]. As shown in FIG. 6A, this results in $X_{LTP}[0] = X_d[0]$, $X_{LTP}[1] = 0$, $X_{LTP}[2] = X_d[1]$, ... $X_{LTP}[1023] = 0$.

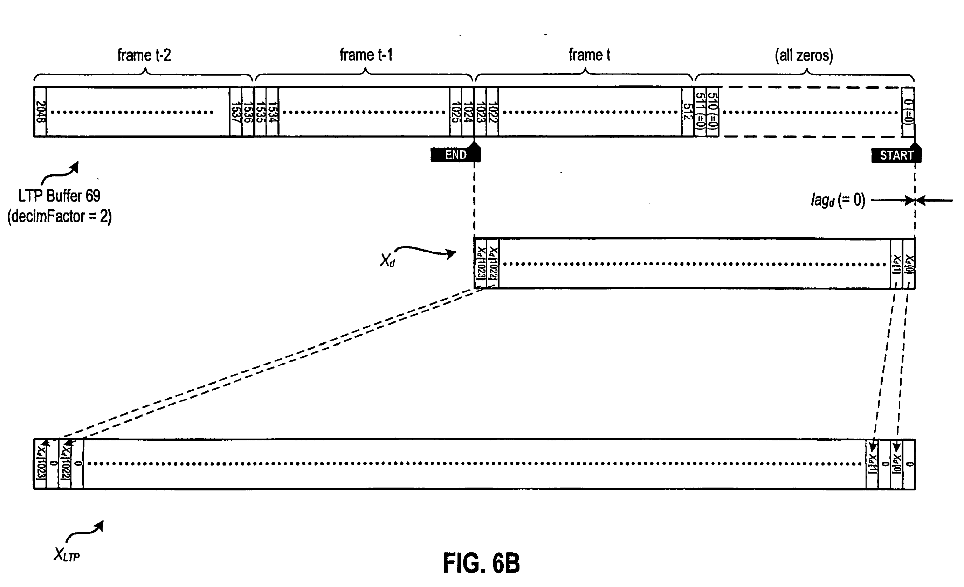

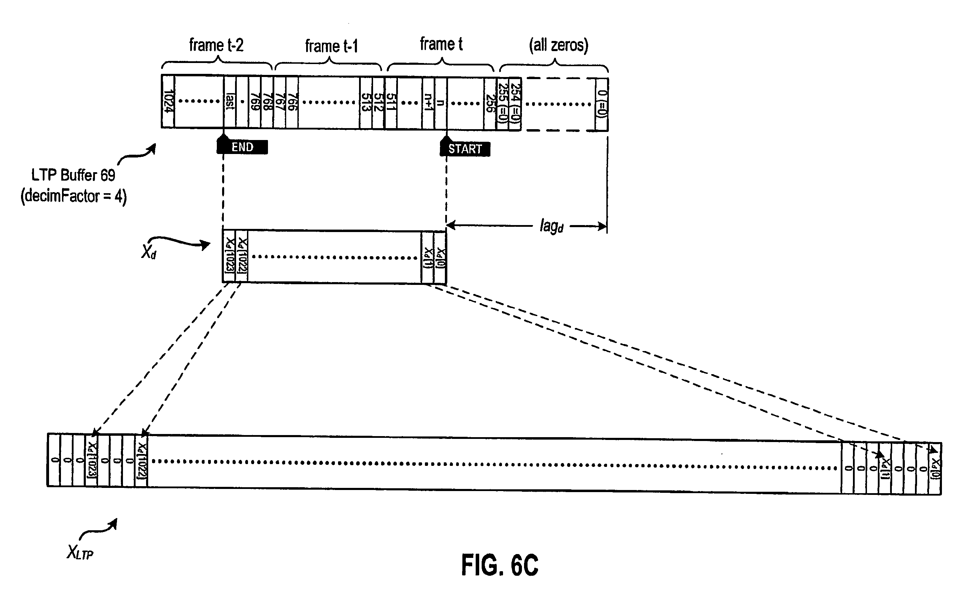

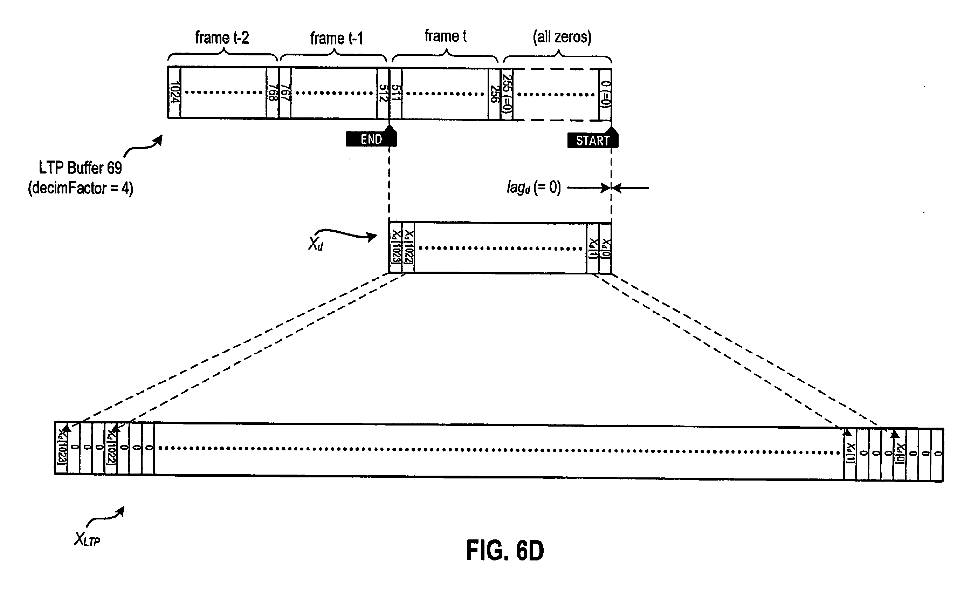

In at least some embodiments, and as shown in FIG. 6B, $X_{LTP}$ [ ] is filled in a slightly different manner when a value for the quantity $lagOffset$ = 0 (the calculation of $lagOffset$ is described below). In such a case, the ordering of zeros and $X_d$ [ ] elements is reversed. This is done so as to yield a fully time-aligned predicted time domain signal that represents the same time-wise signal that would result if decimFactor were equal to 1. FIGS. 6C and 6D are similar to FIGS. 6A and 6B, but show generation of $X_{LTP}$ [ ] when decimFactor = 4.

The samples of $X_{LTP}$ [ ] are used by pitch predictor 20 to generate a time domain prediction of the original audio signal. This prediction will approximate the prediction that is output by the long-term predictor within the coder (e.g., the signal transferred from long-term predictor 1 to MDCT 5 in FIG. 1A). The output of pitch predictor 20 is then provided to MDCT 21 for conversion to the frequency domain. In at least some embodiments, this results in an array $X_{MDCT}$ [ ] containing MDCT coefficients. As can be appreciated by persons skilled in the art, $X_{MDCT}$ [ ] will not necessarily have the same number of elements as $X_{LTP}$ [ ]. The MDCT coefficients in $X_{MDCT}$ [ ] are then provided to IFSS 67. IFSS 67 then adds the coefficients of $X_{MDCT}$ [ ] to the dequantized error prediction coefficients (e.g., the output from summer 6 of FIG. 1A) in a manner described below.

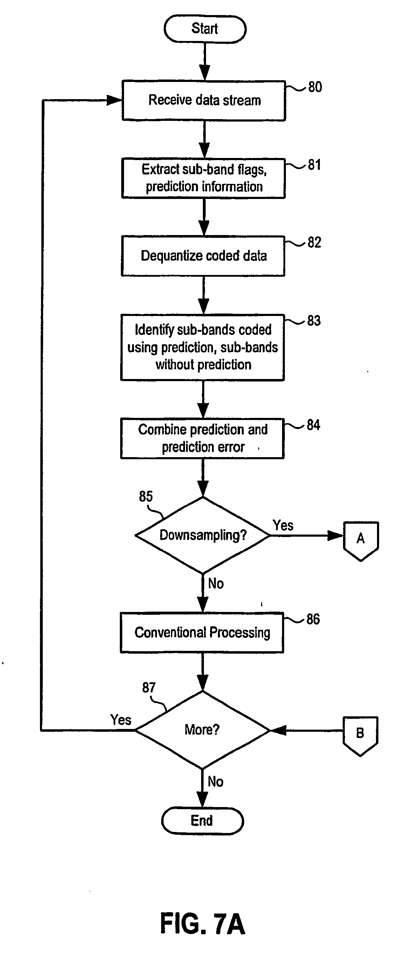

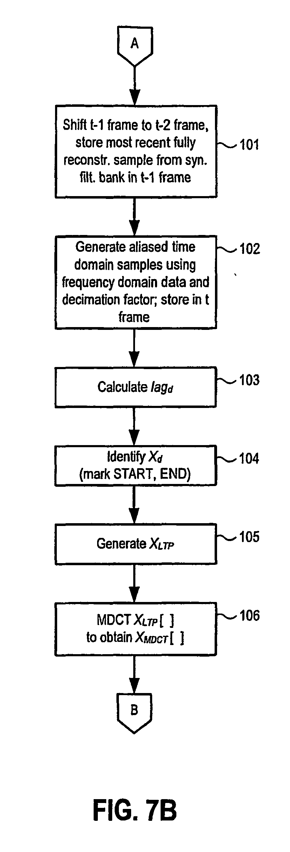

FIGS. 7A and 7B are flow charts showing operation of an AAC-LTP decoder according to at least some embodiments, and as described above in connection with FIGS. 4-6D. Decoder operation commences in FIG. 7A and proceeds to block 80, where an incoming data stream is received (e.g., by bit stream demultiplexer 15). The incoming data stream includes sub-band flags and prediction information (e.g., prediction coefficients and a pitch lag output by predictor 1 of FIG. 1A), as well as quantized frequency domain data. For some sub-bands, the frequency domain data is the result of an MDCT on an original audio input (e.g., as output by MDCT 2 of FIG. 1A). For other sub-bands, the frequency domain data are prediction error values (e.g., as output by summer 6 in FIG. 1A).

The decoder proceeds to block 81, where the sub-band flags and prediction information is extracted from received data stream. The sub-band flags are forwarded to IFSS 67 (FIG. 4), and the prediction information is forwarded to pitch predictor 20. The pitch lag is also forwarded to pre-processor 70. Returning to FIG. 7A, the decoder next proceeds to block 82, where the quantized frequency domain data is dequantized and forwarded to IFSS 67. Operation proceeds to block 83, where the decoder identifies (using the sub-band flags and IFSS 67) sub-bands that are to be reproduced using predictive data and sub bands that are to be reproduced from MDCT coefficients of the original input audio.

In block 84, and as to the sub-bands which will be reproduced using predictive data, the decoder combines the dequantized prediction error values (output from summer 6 in FIG. 1A) with frequency domain predictions based on the contents of LTP buffer 69 ($X_{MDCT}$ [ ], as described above). Specifically, the frequency domain samples from MDCT 21 ($X_{MDCT}$ [ ]) are scaled and added to the prediction error values (represented for convenience as an array $X_q$ [ ]). When downsampling is not occurring, the values in $X_{MDCT}$ [ ] are scaled by a factor ($c_{LTP}$) transmitted in the data stream to the decoder. When downsampling is occurring, the decoder adds $X_{MDCT}$ [ ] to $X_q$ [ ] in IFSS 67 according to the following pseudo code (which follows the syntax of the C programming language).

```
for (sfb = 0; sfb < ltp_bands; sfb++)
    if (ltp_used [sfb])
    {
        for (bin = startBinOffset [sfb]; bin < endBinOffset [sfb]; bin++)
            Xq [bin] = Xq [bin] + XMDCT [bin] * scale;
    }
```

In the above code, "ltp_bands" is the frequency band limit for which prediction error signals can be transmitted. For embodiments implemented in connection with AAC-LTP encoding, this value is specified by the applicable MPEG-4 standard. In other words, the psychoacoustic model will typically specify sub-bands of the incoming audio signal that are to be represented by MDCT coefficients (output by MDCT 2 of FIG. 1A) or by error prediction coefficients (output by summer 6 of FIG. 1A). If each of these sub-bands is numbered 0, 1, 2, ... k, "ltp_bands" is the highest of those numbers corresponding to a sub-band in which long-term prediction was used. The value "ltp_used [sfb]" indicates whether, for sub-band sfb, long-term prediction is enabled. In other words, ltp_used [ ] is an array of the sub-band flags input to IFSS 67 in FIG. 4. The arrays "startBinOffset [ ]" and "endBinOffset [ ]" contain starting and ending indices, respectively, for each sub-band. In particular, startBinOffset [sfb] and endBinOffset [sfb] are the respective starting and ending indices for sub-band sfb. The starting and ending indices for all sub-bands are also specified by the applicable MPEG-4 standards. The variable "scale" is either $c_{LTP}$ or an adaptive correction factor derived from the LTP coefficient and from the properties of the quantized spectra, as set forth in Equation 1.

$$\text{Equation 1:} \quad \text{scale} = \begin{cases} c_{LTP}, & \text{if decimFactor} == 1 \\ c2_{LTP}, & \text{otherwise} \end{cases}$$

where

$$c2_{LTP} = MIN\left(1, \prod_{i=0}^{decimFactor-1} c_{LTP}\right) \text{ if the quantized values for band sub are zero, or else}$$

$$c2LTP = c_{LTP}$$

As can be appreciated by persons skilled in the art, there may be no prediction values ($X_{MDCT}$ [ ]) during one or more initial passes through the loop of the algorithm shown by FIG. 7A. In such cases, $X_{MDCT}$ [ ] can be initially seeded with zeros.

From block 84, the decoder proceeds to block 85 and determines (e.g., based on a received decimation factor) whether downsampling is to be performed. If not, the decoder proceeds on the "No" branch to block 86 and processes the frequency domain data from IFSS 67 in a conventional manner. Preprocessor 70 (FIG. 4) is inactive when there is no downsampling, and $X_{LTP}$ [ ] is obtained from LTP buffer 69 in a conventional manner. From block 86 the decoder proceeds to block 87 (described below). If at block 85 the decoder determines that downsampling is to be performed, the decoder proceeds, via off-page connector A, to FIG. 7B.

In block 101 of FIG. 7B, the decoder shifts the contents of the t-1 frame of LTP buffer 69 to the t-2 frame, and stores the samples from the most recent fully-reconstructed time domain frame (output by the synthesis filter bank) in the t-I frame. In block 102, and using IMDCT 68, the decoder generates aliased time domain data samples using the frequency domain data from IFSS 67 and the decimation factor, and stores those aliased samples in frame t of LTP buffer 69. In block 103, the decoder calculates a value for $lag_d$ using Equations 2 and 3.

$$\text{Equation 2:} \quad lagOffset = \left( ltp\_lag - \left\lfloor \frac{ltp\_lag}{decimFactor} \right\rfloor * decimFactor \right)$$

$$\text{Equation 3:} \quad lag_d = \left\lfloor \frac{ltp\_lag}{decimFactor} \right\rfloor + lagOffset$$

The quantity "ltp_lag" in Equations 2 and 3 is the value for pitch lag transmitted by the coder, and which value assumes the LTP buffer is of conventional size. The "⌊ ⌋" represent a floor function that returns a value representing the largest integer that is less than or equal to the floor function argument.

The decoder next proceeds to block 104 and marks the "START" and "END" points in the LTP buffer, and generates the array $X_d$ [ ]. The decoder then proceeds to block 105 and generates the array $X_{LTP}$ [ ] from $X_d$ [ ]. Set forth below is pseudo code, generally following the syntax of the C programming language, for generating $X_{LTP}$ [ ] according to at least some embodiments.

```
fullldx, predLastldx;
fullldx = (N * decimFactor) - 1;
predLastldx = N - 1;
for (i = predLastldx; i >=0; i--)
{
        if (lagOffset)
        {
                for (j = 0; j < decimFactor -1; j++)
                    XLTP [fullldx--] = 0;

                XLTP [fullldx--] = Xd [i]
        }
        else
        {
                XLTP [fullldx--] = Xd [i];
                for (j = 0; j < decimFactor - 1; j++)
                    XLTP [fullldx--] = 0;        .
        }
}
```

The variable "N" in the above code is the size of each LTP buffer 69 frame in the presence of downsampling. For the examples of FIGS. 6A through 6D, N is equal to 1024/decimFactor. Although typical values for decimFactor are 2 and 4, other values could also be used. Similarly, the invention is not limited to use in conjunction with systems employing an LTP buffer frame size, in the absence of downsampling, of 1024 samples. The operators "--" and "++" indicate decrementing and incrementing, respectively, during each pass through a loop.

The decoder then proceeds to block 106 and performs an MDCT upon $X_{LTP}$ [ ] to obtain an array of frequency domain coefficients $X_{MDCT}$ [ ]. The newly calculated $XM_{DCT}$ [ ] values are forwarded to IFSS 67 for combination with prediction error values ($X_q$ [ ]) to be received in a subsequent portion of the data stream. From block 106, the decoder returns (via off page connector B) to block 87 of FIG. 7A. In block 87, the decoder determines if there is additional audio data to process. If so, the decoder returns to block 80 on the "Yes" branch. Otherwise, the algorithm ends.

In at least some embodiments, the decoder is also able to accommodate "upsampling." In other words, it is sometimes desirable to increase (by interpolation of MDCT coefficients received from a coder) the number of MDCT coefficients that are used to create a time domain output signal. This may be performed, e.g., to generate a signal that is compatible with other devices. However, upsampling can also cause a mismatch between the LTP buffer in the coder and the LTP buffer in the decoder. For example, when decoding conventional AAC-LTP audio, an upsampling (or interpolation) factor of 2 will result in LTP buffer frames having 2048 samples unless additional steps are taken.

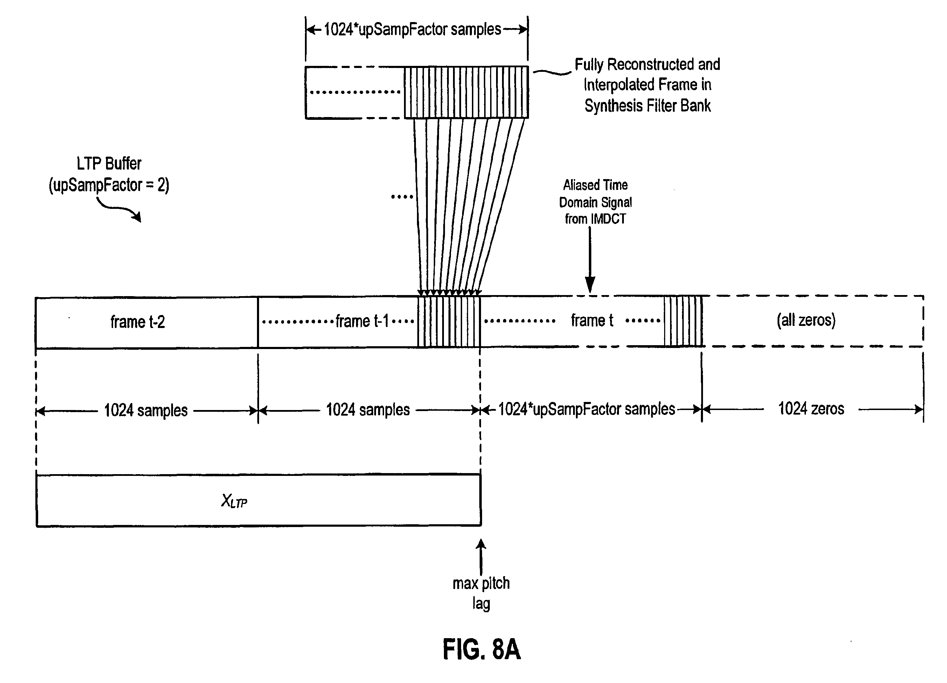

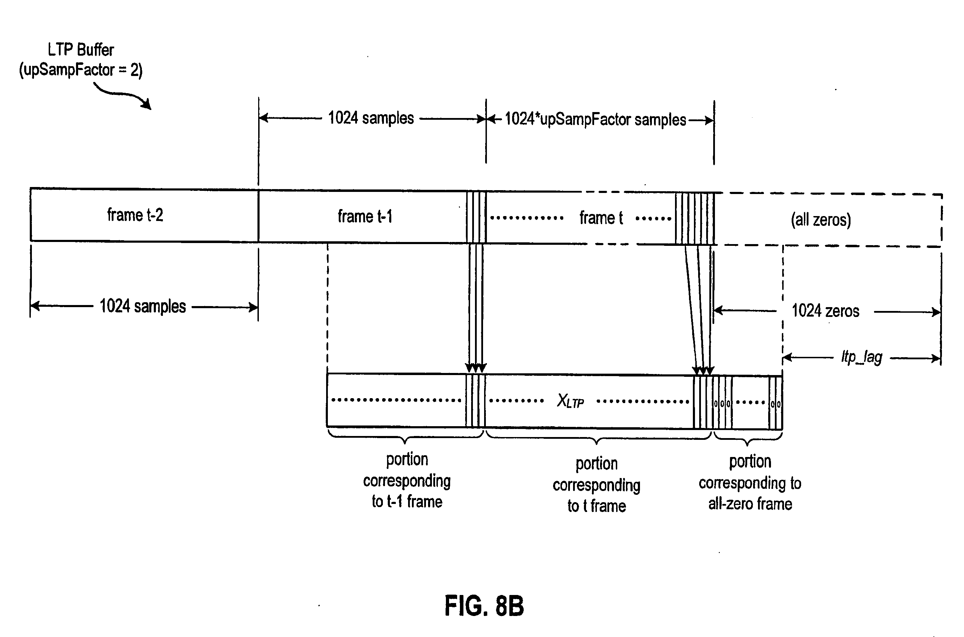

FIGS. 8A and 8B illustrates how an LTP buffer is adapted, in at least some embodiments, to adjust for upsampling. FIGS. 8A and 8B assume an upsampling (or interpolation) factor "upSampFactor" of 2, although other values could also be used. As shown in FIG. 8A, only every upSampFactor[th] sample from the fully-reconstructed frame output by the synthesis filter bank is moved into the t-1 LTP buffer frame, with the t-1 frame moved to the t-2 frame during the subsequent time period. Frame t holds the most recent aliased and interpolated time domain signal output by the IMDCT. As shown in FIG. 8A, frame t has a size of 1024*upSampFactor. In at least some implementations, the t frame is not part of the LTP buffer. The aliased time domain IMDCT output is instead buffered elsewhere within the decoder. In such implementations, access to the data represented by the t frame is achieved by address pointers to memory locations used to buffer the aliased and interpolated IMDCT output during overlap-add. A similar point arrangement could be implemented for the t frame in the embodiments of FIGS. 4-7B.

When pitch lag is at its maximum value, and as shown in FIG. 8A, $LTP$ [ ] is obtained directly from the t-1 and t-2 frames. When pitch lag is less than maximum, and as shown in FIG. 8B, the portion of $X_{LTP}$ [ ] extending beyond the t frame is filled directly from the t-1 frame and (in some cases) the t-2 frame. The portion of $X_{LTP}$ [ ] corresponding to the all-zero "frame" is filled with zeros. The portion of $LTP$ [ ] corresponding to the t frame is filled by taking every upSwnpFactor [th] sample from the t frame. For simplicity, transfer of samples to the t and the t-1 frame is not shown in FIG. 8B.

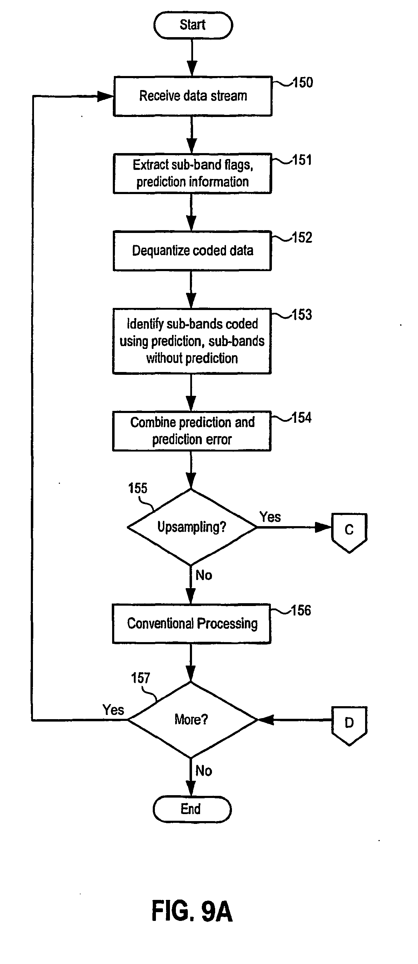

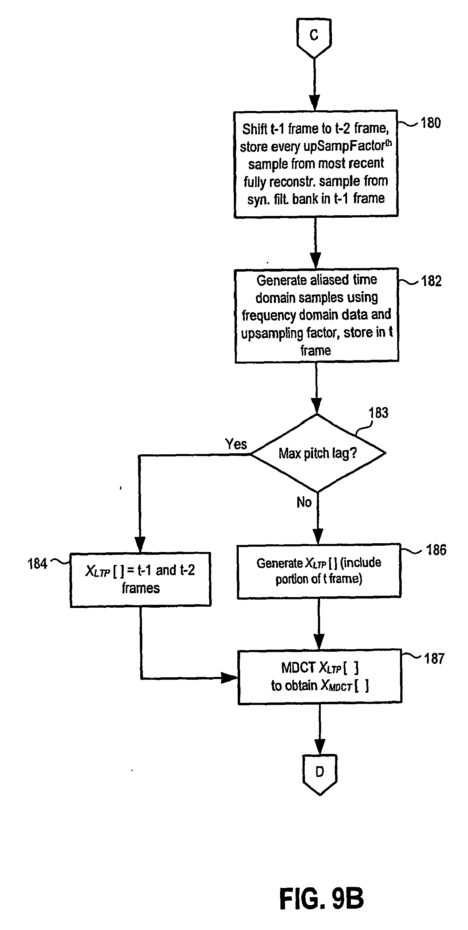

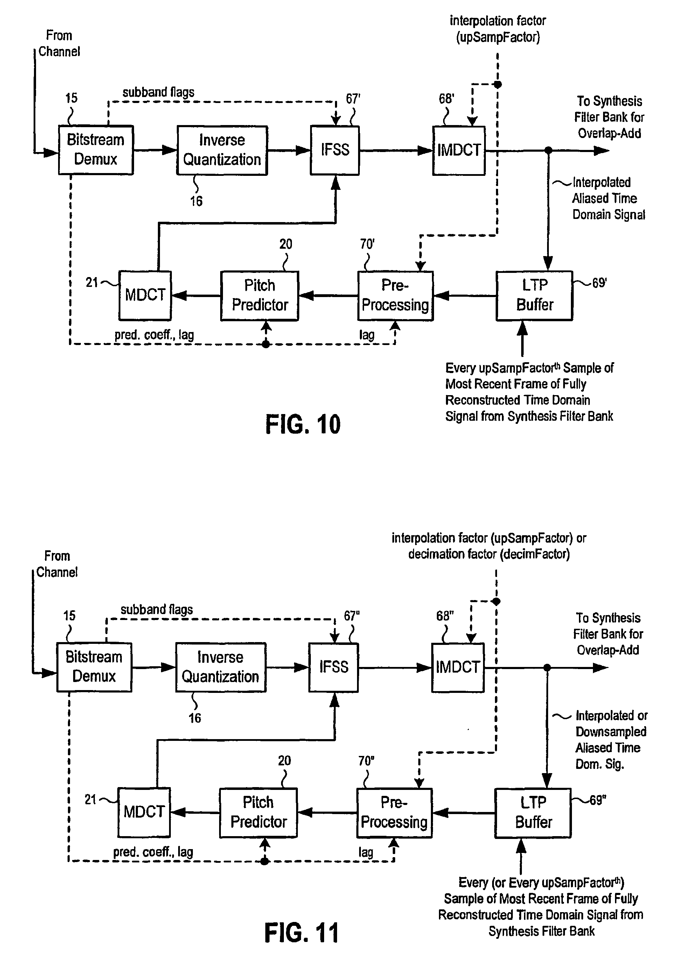

FIGS. 9A and 9B are flow charts showing operation of an AAC-LTP decoder, according to at least some embodiments, when upsampling is taking place. The operations corresponding to blocks 150-153, 156 and 157 are generally the same as those corresponding to blocks 80-83, 86 and 87 described in connection with FIG. 7A, and thus not further discussed. The operations corresponding to block 154 are similar to those of block 84, except with regard to scaling of $MDCT$ [ ] values when upsampling is taking place. Within IFSS 67' (see FIG. 10, discussed below), the decoder adds $MDCT$ [ ] to $Xq$ [ ] according to the same pseudo code discussed above for block 84 of FIG. 7A. In the algorithm of FIG. 9A, however, the variable "scale" is set to $c_{LTP}$ *upSampFactor. Block 155 is also similar to block 85 of FIG. 7A, except that the decoder determines in block 155 (e.g., based on a received upsampling or interpolation factor) whether upsampling is to be performed. If so, the decoder proceeds via off-page connector C, to FIG. 9B.

In block 180 of FIG. 9B, the decoder shifts the contents of the t-1 frame of LTP buffer 69' (FIG. 10) to the t-2 frame. The decoder also stores every upSampFactor[th] sample from the most recent fully-reconstructed time domain sample (from the synthesis filter bank) in the t-1 frame. In block 182, the decoder generates interpolated and aliased time domain data samples using the frequency domain data from IFSS 67' and the upsampling factor, and stores those aliased samples in frame t. In block 183, the decoder determines if pitch lag *(ltp_lag)* is at its maximum value. If so, the decoder proceeds on the "Yes" branch to block 184, *where $X_{LTP}$* [ ] is filled from the t-1 and t-2 buffer frames. From block 184, the decoder then proceeds to block 187 (discussed below).

If pitch lag is less than maximum, the decoder proceeds on the "No" branch from block 183 to block 186. In block 186, $X_{LTP}$ [ ] is generated using the *ltp_lag* value transmitted from the decoder. For portions of $X_{LTP}$ [ ] that correspond to the t frame, only every upSampFactor[th] sample is copied to $LTP$ [ ]. From block 186, the decoder proceeds to block 187 and performs an MDCT upon $LTP$ [ ] to obtain an array of frequency domain coefficients $MDCT$ [ ]. From block 187, the decoder returns to block 157 (FIG. 9A) via off page connector D.

FIG. 10 is a block diagram of a decoder, according to at least some embodiments, configured to perform the operations of FIGS. 9A and 9B. Components 15, 16, 20 and 21 are similar to like-numbered components described in conjunction with FIGS. 1B and 4. Components 67, 68', 69' and 70' are similar to components 67, 68, 69 and 70 of FIG. 4, but are configured to accommodate upsampling in the manner described above in conjunction with FIGS. 8A-9B. FIG. 11 is a block diagram of a decoder, according to at least some additional embodiments, configured to accommodate both upsampling and downsampling. Components 15, 16, 20 and 21 are similar to like-numbered components described in conjunction with FIGS. 1B, 4 and 10. Components 67", 68", 69" and 70" are similar to components 67, 68, 69 and 70 of FIG. 4, but are also configured to accommodate upsampling in the manner described above in conjunction with FIGS. 8A-9B.

Although specific examples of carrying out the invention have been described, those skilled in the art will appreciate that there are numerous variations and permutations of the above-described systems and methods that are contained within the scope of the invention as set forth in the appended claims. For example, the invention may also be implemented as a machine-readable medium (e.g., RAM, ROM, a separate flash memory, etc.) having machine-executable instructions stored thereon such that, when the instructions are read and executed by an appropriate device (or devices), steps of a method according to the invention are performed. As yet another example, decoders such as are described above could also be implemented in numerous other types of devices (e.g., portable music players and other types of consumer electronic devices). These and other modifications are within the scope of the invention as set forth in the attached claims. In the claims, various portions are prefaced with letter or number references for convenience. However, use of such references does not imply a temporal relationship not otherwise required by the language of the claims.

**Claims**

1. A method comprising:

   receiving (80) a stream containing coded audio data and predictive information associated with the coded audio data, the predictive information having been generated based on data in a long-term prediction coding buffer and the predictive information including a pitch lag value;
   receiving (80) a factor indicative of an amount by which the coded audio data is to be either upsampled or downsampled as part of decoding the coded audio data;
   generating (81, 82, 83, 84, 102) decoded data from the coded audio data using the received factor and the predictive information;
   buffering (102) at least a portion of the decoded data in one or more buffers, at least one of the one or more buffers having at least one dimension different from a corresponding dimension of the long-term prediction coding buffer;
   identifying (103, 104) at least a portion of the buffered decoded data for use in decoding subsequent coded audio data, wherein said identifying of at least a portion includes computing a modified pitch lag value; and
   modifying (105) the identified data to correspond to the at least one long-term prediction coding buffer dimension, either wherein the factor received in said receiving of a factor is indicative of an amount by which the coded audio data is to be downsampled and said modifying of the identified data includes interleaving zero values between elements of the identified data;
   or wherein the factor received in said receiving of a factor is an upsampling factor, upSampFactor, said buffering of at least a portion includes buffering a frame t holding N*upSampFactor aliased time domain samples, N is the corresponding long-term prediction coding buffer dimension, and said buffering of at least a portion further includes buffering a frame t-I by transferring every upSampFactor $^{th}$ sample from a fully-reconstructed time domain frame for a recent time period to the frame t-1.

2. A method according to claim 1, wherein

   the coded audio data includes frequency domain data generated using one or more modified discrete cosine transforms, and
   said generating of decoded data includes generating time domain data from the frequency domain data using one or more inverse modified discrete cosine transforms.

3. A method according to claim 2, wherein

   the factor received in said receiving of a factor is a decimation factor indicative of downsampling, and
   said identifying of at least a portion includes calculating the modified pitch lag value based on

$$lagOffset = \left( ltp\_lag - \left\lfloor \frac{ltp\_lag}{decimFactor} \right\rfloor * decimFactor \right)$$

and

$$lag_d = \left\lfloor \frac{ltp\_lag}{decimFactor} \right\rfloor + lagOffset ,$$

where $lag_d$ is the modified pitch lag value, $ltp\_lag$ is the pitch lag value included in the received predictive information, and $decimFactor$ is the decimation factor.

4. A method according to claim 2, wherein

the coded audio data includes prediction error coefficients, and
said generating of decoded data includes

performing a modified discrete cosine transform upon modified identified data from an earlier performance of said modifying of the identified data,
scaling the data resulting from said performing of a modified discrete cosine transform, and
adding the scaled data from said scaling of the data to the prediction error coefficients.

5. A method according to claim 4, wherein the coded audio data includes frequency sub-bands, wherein said scaling of the data includes, as to each sub-band, scaling the data resulting from said performing of a modified discrete cosine transform according to

$$scale = \begin{cases} c_{LTP}, & \text{if } decimFactor = 1 \\ c2_{LTP}, & \text{otherwise} \end{cases}$$

where

scale is a scaling factor applied to elements of the data from said performing of a modified discrete cosine transform, decimFactor is the factor received in said receiving of a factor and indicative of downsampling, $c_{LTP}$ is an LTP coefficient included in the stream received in said receiving of a stream,

$$c2_{LTP} = MIN\left( 1, \prod_{i=0}^{decimFactor-1} c_{LTP} \right) \text{ if the quantized values for the sub-band are zero, or else}$$

$c2_{LTP} = c_{LTP}$.

6. A method according to claim 1, wherein

the coded audio data includes frequency domain data generated using one or more modified discrete cosine transforms,
said generating of decoded data includes generating time domain data from the frequency domain data using one or more inverse modified discrete cosine transforms,
the coded audio data includes prediction error coefficients, and
said generating of decoded data further includes

performing a modified discrete cosine transform upon modified identified data from an earlier performance of said modifying of the identified data,
scaling the data resulting from said performing of a modified discrete cosine transform by a factor $c_{LTP}$ *upSampFactor, where $c_{LTP}$ is an LTP coefficient included in the stream received in said receiving of a stream, and
adding the scaled data from said scaling of the data to the prediction error coefficients.

7. A computer program which, when executed, causes apparatus to perform a method comprising:

receiving (80) a stream containing coded audio data and predictive information associated with the coded audio data, the predictive information having been generated based on data in a long-term prediction coding buffer and the predictive information including a pitch lag value;

receiving (80) a factor indicative of an amount by which the coded audio data is to be either upsampled or downsampled as part of decoding the coded audio data;

generating (81, 82, 83, 84, 102) decoded data from the coded audio data using the received factor and the predictive information;

buffering (102) at least a portion of the decoded data in one or more buffers, at least one of the one or more buffers having at least one dimension different from a corresponding dimension of the long-term prediction coding buffer;

identifying (103, 104) at least a portion of the buffered decoded data for use in decoding subsequent coded audio data, wherein said identifying of at least a portion includes computing a modified pitch lag value; and

modifying (105) the identified data to correspond to the at least one long-term prediction coding buffer dimension either wherein the factor received in said receiving of a factor is indicative of an amount by which the coded audio data is to be downsampled and said modifying of the identified data includes interleaving zero values between elements of the identified data;

or wherein the factor received in said receiving of a factor is an upsampling factor, upSampFactor, said buffering of at least a portion includes buffering a frame t holding N*upSampFactor aliased time domain samples, N is the corresponding long-term prediction coding buffer dimension, and said buffering of at least a portion further includes buffering a frame t-1 by transferring every upSampFactor$^{th}$ sample from a fully-reconstructed time domain frame for a recent time period to the frame t-1.

8. A computer program according to claim 7, wherein

the coded audio data includes frequency domain data generated using one or more modified discrete cosine transforms, and
said generating of decoded data includes generating time domain data from the frequency domain data using one or more inverse modified discrete cosine transforms.

9. A computer program according to claim 8, wherein

the factor received in said receiving of a factor is a decimation factor indicative of downsampling, and
said identifying of at least a portion includes calculating the modified pitch lag value based on

$$lagOffset = \left( ltp\_lag - \left\lfloor \frac{ltp\_lag}{decimFactor} \right\rfloor * decimFactor \right)$$

and

$$lag_d = \left\lfloor \frac{ltp\_lag}{decimFactor} \right\rfloor + lagOffset \, ,$$

where $lag_d$ is the modified pitch lag value, $ltp$-$lag$ is the pitch lag value included in the received predictive information, and $decimFactor$ is the decimation factor.

10. A computer program according to claim 8, wherein

the coded audio data includes prediction error coefficients, and
said generating of decoded data includes

performing a modified discrete cosine transform upon modified identified data from an earlier performance of said modifying of the identified data,
scaling the data resulting from said performing of a modified discrete cosine transform, and
adding the scaled data from said scaling of the data to the prediction error coefficients.

**11.** A computer program according to claim 10, wherein the coded audio data includes frequency sub-bands, wherein said scaling of the data includes, as to each sub-band, scaling the data resulting from said performing of a modified discrete cosine transform according to

$$scale = \begin{cases} c_{LTP}, & \text{if decimFactor} = 1 \\ c2_{LTP}, & \text{otherwise} \end{cases}$$

where

scale is a scaling factor applied to elements of the data from said performing of a modified discrete cosine transform, decimFactor is the factor received in said receiving of a factor and indicative of downsampling, $c_{LTP}$ is an LTP coefficient included in the stream received in said receiving of a stream,

$$c2_{LTP} = MIN\left(1, \prod_{i=0}^{decimFactor-1} c_{LTP}\right)$$ if the quantized values for the sub-band are zero, or else

$c2_{LTP} = c_{LTP}$ .

**12.** A computer program according to claim 7, wherein

the coded audio data includes frequency domain data generated using one or more modified discrete cosine transforms,
said generating of decoded data includes generating time domain data from the frequency domain data using one or more inverse modified discrete cosine transforms,
the coded audio data includes prediction error coefficients, and
said generating of decoded data further includes

performing a modified discrete cosine transform upon modified identified data from an earlier performance of said modifying of the identified data,
scaling the data resulting from said performing of a modified discrete cosine transform by a factor $c_{LTP}$ *upSampFactor, where $c_{LTP}$ is an LTP coefficient included in the stream received in said of receiving a stream, and
adding the scaled data from said scaling of the data to the prediction error coefficients.

**13.** A machine-readable medium including a computer program according to any one of claims 7 to 12.

**14.** Apparatus, comprising:

one or more integrated circuits (43, 44, 46) configured to perform a method for processing data, the method including

receiving (80) a stream containing coded audio data and predictive information associated with the coded audio data, the predictive information having been generated based on data in a long-term prediction coding buffer and the predictive information including a pitch lag value,
receiving (80) a factor indicative of an amount by which the coded audio data is to be either upsampled or downsampled as part of decoding the coded audio data,
generating (81, 82, 83, 84, 102) decoded data from the coded audio data using the received factor and the predictive information,
buffering (102) at least a portion of the decoded data in one or more buffers, at least one of the one or more buffers having at least one dimension different from a corresponding dimension of the long-term prediction coding buffer,
identifying (103, 104) at least a portion of the buffered decoded data for use in decoding subsequent coded audio data, wherein said identifying of at least a portion includes computing a modified pitch lag value, and
modifying (105) the identified data to correspond to the at least one long-term prediction coding buffer dimension

either wherein the factor received in said receiving of a factor is indicative of an amount by which the coded audio data is to be downsampled and said modifying of the identified data includes interleaving zero values between elements of the identified data;
or wherein the factor received in said receiving of a factor is an upsampling factor, upSampFactor, said buffering of at least a portion includes buffering a frame t holding N*upSampFactor aliased time domain samples, N is the corresponding long-term prediction coding buffer dimension, and said buffering of at least a portion further includes buffering a frame t-1 by transferring every upSampFactor[th] sample from a fully-reconstructed time domain frame for a recent time period to the frame t-1.

**15.** Apparatus according to claim 14, wherein the one or more integrated circuits constitute one or more processors.

**16.** Apparatus according to claim 14, wherein

the coded audio data includes frequency domain data generated using one or more modified discrete cosine transforms, and
said generating of decoded data includes generating time domain data from the frequency domain data using one or more inverse modified discrete cosine transforms.

**17.** Apparatus according to claim 16, wherein

the factor received in said receiving of a factor is a decimation factor indicative of downsampling, and
said identifying of at least a portion includes calculating the modified pitch lag value based on

$$lagOffset = \left( ltp\_lag - \left\lfloor \frac{ltp\_lag}{decimFactor} \right\rfloor * decimFactor \right)$$

and

$$lag_d = \left\lfloor \frac{ltp\_lag}{decimFactor} \right\rfloor + lagOffset \, ,$$

where $lag_d$ is the modified pitch lag value, $ltp\_lag$ is the pitch lag value included in the received predictive information, and $decimFactor$ is the decimation factor.

**18.** Apparatus according to claim 16, wherein

the coded audio data includes prediction error coefficients, and
said generating of decoded data includes

performing a modified discrete cosine transform upon modified identified data from an earlier performance of said modifying of the identified data,
scaling the data resulting from said performing of a modified discrete cosine transform, and
adding the scaled data from said scaling of the data to the prediction error coefficients.

**19.** Apparatus according to claim 18, wherein the coded audio data includes frequency sub-bands, wherein said scaling of the data includes, as to each sub-band, scaling the data resulting from said performing of a modified discrete cosine transform according to

$$scale = \begin{cases} c_{LTP}, & \text{if } decimFactor = 1 \\ c2_{LTP}, & \text{otherwise} \end{cases}$$

where

scale is a scaling factor applied to elements of the data from said performing of a modified discrete cosine transform,

decimFactor is the factor received in said receiving of a factor and indicative of downsampling,

$C_{LTP}$ is an LTP coefficient included in the stream received in said receiving of a stream,

$$c2_{LTP} = MIN\left(1, \prod_{i=0}^{decimFactor-1} c_{LTP}\right)$$ if the quantized values for the sub-band are zero, or else

$c2_{LTP} = c_{LTP}$.

20. Apparatus according to claim 14, wherein

the coded audio data includes frequency domain data generated using one or more modified discrete cosine transforms,

said generating of decoded data includes generating time domain data from the frequency domain data using one or more inverse modified discrete cosine transforms,

the coded audio data includes prediction error coefficients, and

said generating of decoded data further includes

performing a modified discrete cosine transform upon modified identified data from an earlier performance of said modifying of the identified data,

scaling the data resulting from said performing of a modified discrete cosine transform by a factor $c_{LTP}$ *upSampFactor, where $c_{LTP}$ is an LTP coefficient included in the stream received in said receiving of a stream, and

adding the scaled data from said scaling of the data to the prediction error coefficients.

21. Apparatus according to claim 14, wherein the apparatus is a mobile communication device (32).

22. Apparatus according to claim 14, wherein the apparatus is a computer (34).

23. Apparatus according to claim 14, wherein the apparatus is a portable music player (32).

24. Apparatus according to claim 14, comprising:

means (68) for conversion for frequency domain samples coding $N$ time domain samples to $N*F$ time domain samples, wherein $F$ is an upsampling or a downsampling factor,

prediction means (20), and

means (69, 70) for adapting the output of the means for conversion for use in the prediction means.

25. Apparatus according to claim 24, wherein

$F$ is an upsampling factor, and

the means for adaptation is configured to update a frame of a long-term prediction buffer with every $F^{th}$ sample from a fully-reconstructed time domain output frame.

26. Apparatus according to claim 24, wherein

$F$ is a downsampling factor, and

the means for adaptation is configured to expand $2N*F$ time domain samples in a portion of a long-term buffer to $2N$ time domain samples.

**Patentansprüche**

1. Verfahren, umfassend:

Empfangen (80) eines Datenstroms, der codierte Audiodaten und Prädiktionsinformationen enthält, die mit den codierten Audiodaten verknüpft sind, wobei die Prädiktionsinformationen basierend auf Daten in einem Langzeit-Prädiktionscodierungspuffer erzeugt wurden und die Prädiktionsinformationen einen Pitch-Lag-Wert enthalten;

Empfangen (80) eines Faktors, der einen Betrag angibt, um den die codierten Audiodaten als Teil des Decodierens der codierten Audiodaten entweder einem Upsampling oder einem Downsampling unterworfen werden sollen;

Erzeugen (81, 82, 83, 84, 102) decodierter Daten aus den codierten Audiodaten unter Verwendung des empfangenen Faktors und der Prädiktionsinformationen;

Puffern (102) mindestens eines Teils der decodierten Daten in einem oder mehreren Puffern, wobei mindestens einer des einen oder der mehreren Puffer mindestens eine Dimension aufweist, die sich von einer entsprechenden Dimension des Langzeit-Prädiktionscodierungspuffers unterscheidet;

Identifizieren (103, 104) mindestens eines Teils der gepufferten decodierten Daten zur Verwendung beim Decodieren nachfolgender codierter Audiodaten, wobei das Identifizieren mindestens eines Teils das Errechnen eines modifizierten Pitch-Lag-Wertes einschließt; und

Modifizieren (105) der identifizierten Daten, so dass sie der mindestens einen Dimension des Langzeit-Prädiktionscodierungspuffers entsprechen,

wobei entweder der bei dem Empfangen eines Faktors empfangene Faktor einen Betrag angibt, um den die codierten Audiodaten einem Downsampling zu unterwerfen sind und das Modifizieren der identifizierten Daten ein Interleaving von Nullwerten zwischen Elementen der identifizierten Daten einschließt;

oder wobei der bei dem Empfangen eines Faktors empfangene Faktor ein Upsampling-Faktor, upSampFactor, ist, wobei das Puffern mindestens eines Teils ein Puffern eines Fensters t einschließt, das $N * upSampFactor$ Aliasing-Samples im Zeitbereich beinhaltet, wobei $N$ die entsprechende Dimension des Langzeit-Prädiktionscodierungspuffers ist, und wobei das Puffern mindestens eines Teils weiter ein Puffern eines Fensters t-1 einschließt, indem jedes upSampFactor-te Sample von einem vollständig wiederhergestellten Fenster im Zeitbereich für eine kürzliche Zeitspanne auf das Fenster t-1 übertragen wird.

2. Verfahren nach Anspruch 1, wobei
die codierten Audiodaten Daten im Frequenzbereich enthalten, die unter Verwendung von einer oder mehreren modifizierten diskreten Cosinus-Transformationen erzeugt wurden, und
das Erzeugen von decodierten Daten das Erzeugen von Daten im Zeitbereich aus den Daten im Frequenzbereich unter Verwendung von einer oder mehreren inversen modifizierten diskreten Cosinus-Transformationen einschließt.

3. Verfahren nach Anspruch 2, wobei
der bei dem Empfangen eines Faktors empfangene Faktor ein Dezimations-Faktor ist, der Downsampling angibt, und
wobei das Identifizieren mindestens eines Teils das Berechnen des modifizierten Pitch-Lag-Wertes basierend auf

$$lagOffset = \left( ltp\_lag - \left\lfloor \frac{ltp\_lag}{decimFactor} \right\rfloor * decimFactor \right)$$

und

$$lag_d = \left\lfloor \frac{ltp\_lag}{decimFactor} \right\rfloor + lagOffset ,$$

einschließt,
wobei $lag_d$ der modifizierte Pitch-Lag-Wert ist, $ltp\_lag$ der Pitch-Lag-Wert ist, der in den empfangenen Prädiktionsinformationen enthalten ist, und $decimFactor$ der Dezimations-Faktor ist.

4. Verfahren nach Anspruch 2, wobei
die codierten Audiodaten Prädiktions-Fehler-Koeffizienten enthalten, und
das Erzeugen von decodierten Daten einschließt
Ausführen einer modifizierten diskreten Cosinus-Transformation an modifizierten identifizierten Daten eines früheren Ausführens des Modifizierens der identifizierten Daten,
Skalieren der Daten, die aus dem Ausführen einer modifizierten diskreten Cosinus-Transformation hervorgehen, und
Hinzufügen der skalierten Daten des Skalierens der Daten zu den Prädiktions-Fehler-Koeffizienten.

**5.** Verfahren nach Anspruch 4, wobei die codierten Audiodaten Frequenz-Teilbänder enthalten, wobei das Skalieren der Daten für jedes Teilband Skalieren der Daten, die aus dem Ausführen einer modifizierten diskreten Cosinus-Transformation hervorgehen, gemäß

$$\text{scale} = \begin{cases} c_{LTP}, & \text{falls } decimFactor = 1 \\ c2_{LTP}, & \text{anderenfalls} \end{cases}$$

einschließt,
wobei

scale ein Skalierungsfaktor ist, der auf Elemente der Daten des Ausführens einer modifizierten diskreten Cosinus-Transformation angewendet wird,
decimFactor der bei dem Empfangen eines Faktors empfangene Faktor ist und Downsampling angibt,
$c_{LTP}$ ein LTP-Koeffizient ist, der in dem bei dem Empfangen eines Datenstroms empfangenen Datenstrom enthalten ist,

$$c2_{LTP} = MIN\left(1, \prod_{i=0}^{decimFactor-1} c_{LTP}\right) \text{ falls die quantisierten Werte für die Teilbänder Null sind, oder sonst}$$

$c2_{LTP} = c_{LTP}$.

**6.** Verfahren nach Anspruch 1, wobei
die codierten Audiodaten Daten im Frequenzbereich enthalten, die unter Verwendung von einer oder mehreren modifizierten diskreten Cosinus-Transformationen erzeugt wurden,
wobei das Erzeugen von decodierten Daten das Erzeugen von Daten im Zeitbereich aus den Daten im Frequenzbereich unter Verwendung von einer oder mehreren inversen modifizierten diskreten Cosinus-Transformationen einschließt,
die codierten Audiodaten Prädiktions-Fehler-Koeffizienten enthalten, und
das Erzeugen von decodierten Daten weiter einschließt
Ausführen einer modifizierten diskreten Cosinus-Transformation an modifizierten identifizierten Daten eines früheren Ausführens des Modifizierens der identifizierten Daten,
Skalieren der Daten, die aus dem Ausführen einer modifizierten diskreten Cosinus-Transformation hervorgehen, um einen Faktor $c_{LTP}$ * upSampFactor, wobei $c_{LTP}$ ein LTP-Koeffizient ist, der in dem beim Empfangen eines Datenstroms empfangenen Datenstrom enthalten ist, und
Hinzufügen der skalierten Daten des Skalierens der Daten zu den Prädiktions-Fehler-Koeffizienten.

**7.** Computerprogramm, das, wenn es ausgeführt wird, eine Vorrichtung dazu veranlasst, ein Verfahren auszuführen, das umfasst:

Empfangen (80) eines Datenstroms, der codierte Audiodaten und Prädiktionsinformationen enthält, die mit den codierten Audiodaten verknüpft sind, wobei die Prädiktionsinformationen basierend auf Daten in einem Langzeit-Prädiktionscodierungspuffer erzeugt wurden und die Prädiktionsinformationen einen Pitch-Lag-Wert enthalten;
Empfangen (80) eines Faktors, der einen Betrag angibt, um den die codierten Audiodaten als Teil des Decodierens der codierten Audiodaten entweder einem Upsampling oder einem Downsampling unterworfen werden sollen;
Erzeugen (81, 82, 83, 84, 102) decodierter Daten aus den codierten Audiodaten unter Verwendung des empfangenen Faktors und der Prädiktionsinformationen;
Puffern (102) mindestens eines Teils der decodierten Daten in einem oder mehreren Puffern, wobei mindestens einer des einen oder der mehreren Puffer mindestens eine Dimension aufweist, die sich von einer entsprechenden Dimension des Langzeit-Prädiktionscodierungspuffers unterscheidet;

Identifizieren (103, 104) mindestens eines Teils der gepufferten decodierten Daten zur Verwendung beim Decodieren nachfolgender codierter Audiodaten, wobei das Identifizieren mindestens eines Teils das Errechnen eines modifizierten Pitch-Lag-Wertes einschließt; und

Modifizieren (105) der identifizierten Daten, so dass sie der mindestens einen Dimension des Langzeit-Prädiktionscodierungspuffers entsprechen,

wobei entweder der bei dem Empfangen eines Faktors empfangene Faktor einen Betrag angibt, um den die codierten Audiodaten einem Downsampling zu unterwerfen sind und das Modifizieren der identifizierten Daten ein Interleaving von Nullwerten zwischen Elementen der identifizierten Daten einschließt;

oder wobei der bei dem Empfangen eines Faktors empfangene Faktor ein Upsampling-Faktor, upSampFactor, ist, wobei das Puffern mindestens eines Teils ein Puffern eines Fensters t einschließt, das *N* * upSampFactor Aliasing-Samples im Zeitbereich beinhaltet, wobei *N* die entsprechende Dimension des Langzeit-Prädiktionscodierungspuffers ist, und wobei das Puffern mindestens eines Teils weiter ein Puffern eines Fensters t-1 einschließt, indem jedes upSampFactor-te Sample von einem vollständig wiederhergestellten Fenster im Zeitbereich für eine kürzliche Zeitspanne auf das Fenster t-1 übertragen wird.

**8.** Computerprogramm nach Anspruch 7, wobei
die codierten Audiodaten Daten im Frequenzbereich enthalten, die unter Verwendung von einer oder mehreren modifizierten diskreten Cosinus-Transformationen erzeugt wurden, und
das Erzeugen von decodierten Daten das Erzeugen von Daten im Zeitbereich aus den Daten im Frequenzbereich unter Verwendung von einer oder mehreren inversen modifizierten diskreten Cosinus-Transformationen einschließt.

**9.** Computerprogramm nach Anspruch 8, wobei
der bei dem Empfangen eines Faktors empfangene Faktor ein Dezimations-Faktor ist, der Downsampling angibt, und wobei das Identifizieren mindestens eines Teils das Berechnen des modifizierten Pitch-Lag-Wertes basierend auf

$$lagOffset = \left( ltp\_lag - \left\lfloor \frac{ltp\_lag}{decimFactor} \right\rfloor * decimFactor \right)$$

und

$$lag_d = \left\lfloor \frac{ltp\_lag}{decimFactor} \right\rfloor + lagOffset ,$$

einschließt,
wobei *lag_d* der modifizierte Pitch-Lag-Wert ist, *ltp-lag* der Pitch-Lag-Wert ist, der in den empfangenen Prädiktionsinformationen enthalten ist, und *decimFactor* der Dezimations-Faktor ist.

**10.** Computerprogramm nach Anspruch 8, wobei
die codierten Audiodaten Prädiktions-Fehler-Koeffizienten enthalten, und
das Erzeugen von decodierten Daten einschließt
Ausführen einer modifizierten diskreten Cosinus-Transformation an modifizierten identifizierten Daten eines früheren Ausführens des Modifizierens der identifizierten Daten,
Skalieren der Daten, die aus dem Ausführen einer modifizierten diskreten Cosinus-Transformation hervorgehen, und
Hinzufügen der skalierten Daten des Skalierens der Daten zu den Prädiktions-Fehler-Koeffizienten.

**11.** Computerprogramm nach Anspruch 10, wobei die codierten Audiodaten Frequenz-Teilbänder enthalten, wobei das Skalieren der Daten für jedes Teilband Skalieren der Daten, die aus dem Ausführen einer modifizierten diskreten Cosinus-Transformation hervorgehen, gemäß

$$\text{scale} = \begin{cases} c_{LTP}, & \text{falls decimFactor} = 1 \\ c2_{LTP}, & \text{anderenfalls} \end{cases}$$

einschließt,
wobei

scale ein Skalierungsfaktor ist, der auf Elemente der Daten des Ausführens einer modifizierten diskreten Cosinus-Transformation angewendet wird,
decimFactor der bei dem Empfangen eines Faktors empfangene Faktor ist und Downsampling angibt,
$c_{LTP}$ ein LTP-Koeffizient ist, der in dem bei dem Empfangen eines Datenstroms empfangenen Datenstrom enthalten ist,

$$c2_{LTP} = MIN\left(1, \prod_{i=0}^{\text{decimFactor-1}} c_{LTP}\right) \text{ falls die quantisierten Werte für die Teilbänder Null sind, oder sonst}$$

$c2_{LTP} = c_{LTP}.$

**12.** Computerprogramm nach Anspruch 7, wobei
die codierten Audiodaten Daten im Frequenzbereich enthalten, die unter Verwendung von einer oder mehreren modifizierten diskreten Cosinus-Transformationen erzeugt wurden,
wobei das Erzeugen von decodierten Daten das Erzeugen von Daten im Zeitbereich aus den Daten im Frequenzbereich unter Verwendung von einer oder mehreren inversen modifizierten diskreten Cosinus-Transformationen einschließt,
die codierten Audiodaten Prädiktions-Fehler-Koeffizienten enthalten, und
das Erzeugen von decodierten Daten weiter einschließt
Ausführen einer modifizierten diskreten Cosinus-Transformation an modifizierten identifizierten Daten eines früheren Ausführens des Modifizierens der identifizierten Daten,
Skalieren der Daten, die aus dem Ausführen einer modifizierten diskreten Cosinus-Transformation hervorgehen, um einen Faktor $c_{LTP}$ * upSampFactor, wobei $c_{LTP}$ ein LTP-Koeffizient ist, der in dem beim Empfangen eines Datenstroms empfangenen Datenstrom enthalten ist, und
Hinzufügen der skalierten Daten des Skalierens der Daten zu den Prädiktions-Fehler-Koeffizienten.

**13.** Maschinenlesbares Medium, enthaltend ein Computerprogramm nach einem der Ansprüche 7 bis 12.

**14.** Vorrichtung, umfassend:

eine oder mehrere integrierte Schaltungen (43, 44, 46), die konfiguriert sind, ein Verfahren zum Verarbeiten von Daten auszuführen, wobei das Verfahren einschließt Empfangen (80) eines Datenstroms, der codierte Audiodaten und Prädiktionsinformationen enthält, die mit den codierten Audiodaten verknüpft sind,
wobei die Prädiktionsinformationen basierend auf Daten in einem Langzeit-Prädiktionscodierungspuffer erzeugt wurden und die Prädiktionsinformationen einen Pitch-Lag-Wert enthalten;
Empfangen (80) eines Faktors, der einen Betrag angibt, um den die codierten Audiodaten als Teil des Decodierens der codierten Audiodaten entweder einem Upsampling oder einem Downsampling unterworfen werden sollen;
Erzeugen (81, 82, 83, 84, 102) decodierter Daten aus den codierten Audiodaten unter Verwendung des empfangenen Faktors und der Prädiktionsinformationen;
Puffern (102) mindestens eines Teils der decodierten Daten in einem oder mehreren Puffern, wobei mindestens einer des einen oder der mehreren Puffer mindestens eine Dimension aufweist, die sich von einer entsprechenden Dimension des Langzeit-Prädiktionscodierungspuffers unterscheidet;
Identifizieren (103, 104) mindestens eines Teils der gepufferten decodierten Daten zur Verwendung beim Decodieren nachfolgender codierter Audiodaten, wobei das Identifizieren mindestens eines Teils das Errechnen eines modifizierten Pitch-Lag-Wertes einschließt; und
Modifizieren (105) der identifizierten Daten, so dass sie der mindestens einen Dimension des Langzeit-Prädiktionscodierungspuffers entsprechen,

wobei entweder der bei dem Empfangen eines Faktors empfangene Faktor einen Betrag angibt, um den die codierten Audiodaten einem Downsampling zu unterwerfen sind und das Modifizieren der identifizierten Daten ein Interleaving von Nullwerten zwischen Elementen der identifizierten Daten einschließt;

oder wobei der bei dem Empfangen eines Faktors empfangene Faktor ein Upsampling-Faktor, upSampFactor, ist, wobei das Puffern mindestens eines Teils ein Puffern eines Fensters t einschließt, das $N$ * upSampFactor Aliasing-Samples im Zeitbereich beinhaltet, wobei $N$ die entsprechende Dimension des Langzeit-Prädiktionscodierungspuffers ist, und wobei das Puffern mindestens eines Teils weiter ein Puffern eines Fensters t-1 einschließt, indem jedes upSampFactor-te Sample von einem vollständig wiederhergestellten Fenster im Zeitbereich für eine kürzliche Zeitspanne auf das Fenster t-1 übertragen wird.

**15.** Vorrichtung nach Anspruch 14, wobei die eine oder die mehreren integrierten Schaltungen einen oder mehrere Prozessoren bilden.

**16.** Vorrichtung nach Anspruch 14, wobei
die codierten Audiodaten Daten im Frequenzbereich enthalten, die unter Verwendung von einer oder mehreren modifizierten diskreten Cosinus-Transformationen erzeugt wurden, und
das Erzeugen von decodierten Daten das Erzeugen von Daten im Zeitbereich aus den Daten im Frequenzbereich unter Verwendung von einer oder mehreren inversen modifizierten diskreten Cosinus-Transformationen einschließt.

**17.** Vorrichtung nach Anspruch 16, wobei
der bei dem Empfangen eines Faktors empfangene Faktor ein Dezimations-Faktor ist, der Downsampling angibt, und wobei das Identifizieren mindestens eines Teils das Berechnen des modifizierten Pitch-Lag-Wertes basierend auf

$$lagOffset = \left( ltp\_lag - \left\lfloor \frac{ltp\_lag}{decimFactor} \right\rfloor * decimFactor \right)$$

und

$$lag_d = \left\lfloor \frac{ltp\_lag}{decimFactor} \right\rfloor + lagOffset \, ,$$

einschließt,
wobei $lag_d$ der modifizierte Pitch-Lag-Wert ist, $ltp\_lag$ der Pitch-Lag-Wert ist, der in den empfangenen Prädiktionsinformationen enthalten ist, und $decimFactor$ der Dezimations-Faktor ist.

**18.** Vorrichtung nach Anspruch 16, wobei
die codierten Audiodaten Prädiktions-Fehler-Koeffizienten enthalten, und
das Erzeugen von decodierten Daten einschließt
Ausführen einer modifizierten diskreten Cosinus-Transformation an modifizierten identifizierten Daten eines früheren Ausführens des Modifizierens der identifizierten Daten,
Skalieren der Daten, die aus dem Ausführen einer modifizierten diskreten Cosinus-Transformation hervorgehen, und
Hinzufügen der skalierten Daten des Skalierens der Daten zu den Prädiktions-Fehler-Koeffizienten.

**19.** Vorrichtung nach Anspruch 18, wobei die codierten Audiodaten Frequenz-Teilbänder enthalten, wobei das Skalieren der Daten für jedes Teilband Skalieren der Daten, die aus dem Ausführen einer modifizierten diskreten Cosinus-Transformation hervorgehen, gemäß

$$scale = \begin{cases} c_{LTP}, & \text{falls } decimFactor = 1 \\ c2_{LTP}, & \text{anderenfalls} \end{cases}$$

einschließt,
wobei

scale ein Skalierungsfaktor ist, der auf Elemente der Daten des Ausführens einer modifizierten diskreten Cosinus-Transformation angewendet wird,
decimFactor der bei dem Empfangen eines Faktors empfangene Faktor ist und Downsampling angibt,
$c_{LTP}$ ein LTP-Koeffizient ist, der in dem bei dem Empfangen eines Datenstroms empfangenen Datenstrom enthalten ist,

$$c2_{LTP} = MIN\left(1, \prod_{i=0}^{decimFactor-1} c_{LTP}\right) \text{ falls die quantisierten Werte für die Teilbänder Null sind, oder sonst}$$

$c2_{LTP} = c_{LTP}$.

20. Vorrichtung nach Anspruch 14, wobei
die codierten Audiodaten Daten im Frequenzbereich enthalten, die unter Verwendung von einer oder mehreren modifizierten diskreten Cosinus-Transformationen erzeugt wurden,
wobei das Erzeugen von decodierten Daten das Erzeugen von Daten im Zeitbereich aus den Daten im Frequenzbereich unter Verwendung von einer oder mehreren inversen modifizierten diskreten Cosinus-Transformationen einschließt,
die codierten Audiodaten Prädiktions-Fehler-Koeffizienten enthalten, und
das Erzeugen von decodierten Daten weiter einschließt
Ausführen einer modifizierten diskreten Cosinus-Transformation an modifizierten identifizierten Daten eines früheren Ausführens des Modifizierens der identifizierten Daten,
Skalieren der Daten, die aus dem Ausführen einer modifizierten diskreten Cosinus-Transformation hervorgehen, um einen Faktor $c_{LTP}$ * upSampFactor, wobei $c_{LTP}$ ein LTP-Koeffizient ist, der in dem beim Empfangen eines Datenstroms empfangenen Datenstrom enthalten ist, und
Hinzufügen der skalierten Daten des Skalierens der Daten zu den Prädiktions-Fehler-Koeffizienten.

21. Vorrichtung nach Anspruch 14, wobei die Vorrichtung eine Mobilkommunikationsvorrichtung (32) ist.

22. Vorrichtung nach Anspruch 14, wobei die Vorrichtung ein Computer (34) ist.

23. Vorrichtung nach Anspruch 14, wobei die Vorrichtung eine tragbare Musikabspieleinrichtung (32) ist.

24. Vorrichtung nach Anspruch 14, umfassend:

Mittel (68) für eine Umwandlung für Samples im Frequenzbereich, die *N* Samples im Zeitbereich codieren, in *N* * *F* Samples im Zeitbereich, wobei *F* ein Upsampling- oder
ein Downsampling-Faktor ist,
Prädiktionsmittel (20), und
Mittel (69, 70) zum Anpassen der Ausgabe der Mittel für eine Umwandlung zur Verwendung in den Prädiktionsmitteln.

25. Vorrichtung nach Anspruch 24, wobei
*F ein* Upsampling-Faktor ist, und
das Mittel zur Anpassung konfiguriert ist, ein Fenster eines Langzeit-Prädiktions-Puffers mit jedem ***F***-ten Sample aus einem vollständig wiederhergestellten Ausgabe-Fenster im Zeitbereich zu aktualisieren.

26. Vorrichtung nach Anspruch 24, wobei
**F ein** Downsampling-Faktor ist, und
das Mittel zur Anpassung konfiguriert ist, 2*N* * **F** Samples im Zeitbereich in einem Teil eines Langzeit-Puffers auf 2*N* Samples im Zeitbereich zu expandieren.

**Revendications**

1. Procédé comportant :

   la réception (80) d'un flux contenant des données audio codées et des informations prédictives associées aux données audio codées, les informations prédictives ayant été générées sur la base de données dans une mémoire tampon de codage de prédiction à long terme et les informations prédictives incluant une valeur de retard de hauteur tonale ;
   la réception (80) d'un facteur indiquant une quantité par laquelle les données audio codées doivent être sur-échantillonnées ou sous-échantillonnées dans le cadre du décodage des données audio codées ;
   la génération (81, 82, 83, 84, 102) de données décodées à partir des données audio codées en utilisant le facteur reçu et les informations prédictives ;
   la mise en mémoire tampon (102) d'au moins une partie des données décodées dans une ou plusieurs mémoires tampons, au moins une mémoire tampon parmi ladite une ou lesdites plusieurs mémoires tampons présentant au moins une dimension distincte d'une dimension correspondante de la mémoire tampon de codage de prédiction à long terme ;
   l'identification (103, 104) d'au moins une partie des données décodées mises en mémoire tampon à utiliser en vue du décodage de données audio codées subséquentes, dans lequel ladite identification d'au moins une partie inclut le calcul d'une valeur de retard de hauteur tonale modifiée ; et
   la modification (105) des données identifiées afin qu'elles correspondent à ladite au moins une dimension de mémoire tampon de codage de prédiction à long terme ;
   soit dans lequel le facteur reçu au cours de ladite réception d'un facteur indique une quantité par laquelle les données audio codées doivent être sous-échantillonnées et ladite modification des données identifiées inclut l'entrelacement de valeurs nulles entre des éléments des données identifiées ;
   soit dans lequel le facteur reçu au cours de ladite réception d'un facteur représente un facteur de sur-échantillonnage, « upSampFactor », ladite mise en mémoire tampon d'au moins une partie inclut la mise en mémoire tampon d'une trame « t » contenant $N$*upSampFactor échantillons de domaine temporel crénelés, $N$ représente la dimension de mémoire tampon de codage de prédiction à long terme correspondante, et ladite mise en mémoire tampon d'au moins une partie inclut en outre la mise en mémoire tampon d'une trame « t - 1 » en transférant chaque upSampFactor$^{\text{ième}}$ échantillon d'une trame de domaine temporel totalement reconstituée pour une période de temps récente à la trame « t - 1 ».

2. Procédé selon la revendication 1, dans lequel

   les données audio codées incluent des données de domaine fréquentiel générées en faisant appel à une ou plusieurs transformées en cosinus discrètes modifiées ; et
   ladite génération de données décodées inclut la génération de données de domaine temporel à partir des données de domaine fréquentiel au moyen d'une ou plusieurs transformées en cosinus discrètes modifiées inverses.

3. Procédé selon la revendication 2, dans lequel

   le facteur reçu au cours de ladite réception d'un facteur représente un facteur de décimation indicatif d'un sous-échantillonnage ; et
   ladite identification d'au moins une partie inclut le calcul de la valeur de retard de hauteur tonale modifiée sur la base de l'équation ci-dessous :

$$lagOffset = \left( ltp\_lag - \left\lfloor \frac{ltp\_lag}{decimFactor} \right\rfloor * decimFactor \right)$$

   et

$$lag_d = \left\lfloor \frac{ltp\_lag}{decimFactor} \right\rfloor + lagOffset \,,$$

où *« lag<sub>d</sub> »* représente la valeur de retard de hauteur tonale modifiée, *« ltp _lag »* représente la valeur de retard de hauteur tonale incluse dans les informations prédictives reçues, et *« decimFactor »* représente le facteur de décimation.

**4.** Procédé selon la revendication 2, dans lequel

les données audio codées incluent des coefficients d'erreur de prédiction ; et
ladite génération de données décodées inclut :

la mise en oeuvre d'une transformée en cosinus discrète modifiée sur des données identifiées modifiées à partir d'une mise en oeuvre précédente de ladite modification des données identifiées ;
la mise à l'échelle des données résultant de ladite mise en oeuvre d'une transformée en cosinus discrète modifiée ; et
l'ajout des données mises à l'échelle à partir de ladite mise à l'échelle des données aux coefficients d'erreur de prédiction.

**5.** Procédé selon la revendication 4, dans lequel les données audio codées incluent des sous-bandes de fréquence, dans lequel ladite mise à l'échelle des données inclut, pour chaque sous-bande, la mise à l'échelle des données résultant de ladite mise en oeuvre d'une transformée en cosinus discrète modifiée selon l'équation ci-dessous :

$$\text{scale} = \begin{cases} c_{LTP}, & \text{si decimFactor} = 1 \\ c2_{LTP}, & \text{sinon} \end{cases}$$

où

« scale » représente un facteur de mise à l'échelle appliqué à des éléments des données en provenance de ladite mise en oeuvre d'une transformée en cosinus discrète modifiée ;
« decimFactor » représente le facteur reçu au cours de ladite réception d'un facteur et indicatif d'un sous-échantillonnage ;
$c_{LTP}$ représente un coefficient LTP inclus dans le flux reçu au cours de ladite réception d'un flux ;

$$c2_{LTP} = {}^{MIN\left(1, \prod_{i=0}^{decimFactor-1} c_{LTP}\right)}$$ si les valeurs quantifiées pour la sous-bande sont nulles, ou dans le cas contraire $c2_{LTP} = c_{LTP}$.

**6.** Procédé selon la revendication 1, dans lequel

les données audio codées incluent des données de domaine fréquentiel générées en faisant appel à une ou plusieurs transformées en cosinus discrètes modifiées ;
ladite génération de données décodées inclut la génération de données de domaine temporel à partir des données de domaine fréquentiel au moyen d'une ou plusieurs transformées en cosinus discrètes modifiées inverses,
les données audio codées incluent des coefficients d'erreur de prédiction ; et
ladite génération de données décodées inclut en outre :

la mise en oeuvre d'une transformée en cosinus discrète modifiée sur des données identifiées modifiées à partir d'une mise en oeuvre précédente de ladite modification des données identifiées ;
la mise à l'échelle des données résultant de ladite mise en oeuvre d'une transformée en cosinus discrète modifiée par un facteur « $c_{LTP}$*upSampFactor », où $c_{LTP}$ représente un coefficient LTP inclus dans le flux reçu au cours de ladite réception d'un flux ; et
l'ajout des données mises à l'échelle à partir de ladite mise à l'échelle des données aux coefficients d'erreur de prédiction.

**7.** Programme informatique qui, lorsqu'il est exécuté, amène le dispositif à mettre en oeuvre le procédé comportant :

la réception (80) d'un flux contenant des données audio codées et des informations prédictives associées aux données audio codées, les informations prédictives ayant été générées sur la base de données dans une mémoire tampon de codage de prédiction à long terme et les informations prédictives incluant une valeur de retard de hauteur tonale ;

la réception (80) d'un facteur indiquant une quantité par laquelle les données audio codées doivent être sur-échantillonnées ou sous-échantillonnées dans le cadre du décodage des données audio codées ;

la génération (81, 82, 83, 84, 102) de données décodées à partir des données audio codées en utilisant le facteur reçu et les informations prédictives ;

la mise en mémoire tampon (102) d'au moins une partie des données décodées dans une ou plusieurs mémoires tampons, au moins une mémoire tampon parmi ladite une ou lesdites plusieurs mémoires tampons présentant au moins une dimension distincte d'une dimension correspondante de la mémoire tampon de codage de prédiction à long terme ;

l'identification (103, 104) d'au moins une partie des données décodées mises en mémoire tampon à utiliser en vue du décodage de données audio codées subséquentes, dans lequel ladite identification d'au moins une partie inclut le calcul d'une valeur de retard de hauteur tonale modifiée ; et

la modification (105) des données identifiés afin qu'elles correspondent à ladite au moins une dimension de mémoire tampon de codage de prédiction à long terme ;

soit dans lequel le facteur reçu au cours de ladite réception d'un facteur indique une quantité par laquelle les données audio codées doivent être sous-échantillonnées et ladite modification des données identifiées inclut l'entrelacement de valeurs nulles entre des éléments des données identifiées ;

soit dans lequel le facteur reçu au cours de ladite réception d'un facteur représente un facteur de sur-échantillonnage, « upSampFactor », ladite mise en mémoire tampon d'au moins une partie inclut la mise en mémoire tampon d'une trame « t » contenant $N$*upSampFactor échantillons de domaine temporel crénelés, $N$ représente la dimension de mémoire tampon de codage de prédiction à long terme correspondante, et ladite mise en mémoire tampon d'au moins une partie inclut en outre la mise en mémoire tampon d'une trame « t - 1 » en transférant chaque upSampFactor$^{\text{ième}}$ échantillon d'une trame de domaine temporel totalement reconstituée pour une période de temps récente à la trame « t - 1 ».

8. Programme informatique selon la revendication 7, dans lequel

les données audio codées incluent des données de domaine fréquentiel générées en faisant appel à une ou plusieurs transformées en cosinus discrètes modifiées ; et

ladite génération de données décodées inclut la génération de données de domaine temporel à partir des données de domaine fréquentiel au moyen d'une ou plusieurs transformées en cosinus discrètes modifiées inverses.

9. Programme informatique selon la revendication 8, dans lequel

le facteur reçu au cours de ladite réception d'un facteur représente un facteur de décimation indicatif d'un sous-échantillonnage ; et

ladite identification d'au moins une partie inclut le calcul de la valeur de retard de hauteur tonale modifiée sur la base de l'équation ci-dessous :

$$lagOffset = \left( ltp\_lag - \left\lfloor \frac{ltp\_lag}{decimFactor} \right\rfloor * decimFactor \right)$$

et

$$lag_d = \left\lfloor \frac{ltp\_lag}{decimFactor} \right\rfloor + lagOffset \, ,$$

où « $lag_d$ » représente la valeur de retard de hauteur tonale modifiée, « $ltp\_lag$ » représente la valeur de retard de hauteur tonale incluse dans les informations prédictives reçues, et « $decimFactor$ » représente le facteur de décimation.

**10.** Programme informatique selon la revendication 8, dans lequel

les données audio codées incluent des coefficients d'erreur de prédiction ; et
ladite génération de données décodées inclut :

la mise en oeuvre d'une transformée en cosinus discrète modifiée sur des données identifiées modifiées à partir d'une mise en oeuvre précédente de ladite modification des données identifiées ;
la mise à l'échelle des données résultant de ladite mise en oeuvre d'une transformée en cosinus discrète modifiée ; et
l'ajout des données mises à l'échelle à partir de ladite mise à l'échelle des données aux coefficients d'erreur de prédiction.

**11.** Programme informatique selon la revendication 10, dans lequel les données audio codées incluent des sous-bandes de fréquence, dans lequel ladite mise à l'échelle des données inclut, pour chaque sous-bande, la mise à l'échelle des données résultant de ladite mise en oeuvre d'une transformée en cosinus discrète modifiée selon l'équation ci-dessous :

$$\text{scale} = \begin{cases} c_{LTP} & \text{si decimFactor} = 1 \\ c2_{LT} & \text{sinon} \end{cases}$$

où « scale » représente un facteur de mise à l'échelle

appliqué à des éléments des données provenant de ladite mise en oeuvre d'une transformée en cosinus discrète modifiée ;
« decimFactor » représente le facteur reçu au cours de ladite réception d'un facteur et indicatif d'un sous-échantillonnage ;
$c_{LTP}$ représente un coefficient LTP inclus dans le flux reçu au cours de ladite réception d'un flux ;

$$c2_{LTP} = MIN\left(1, \prod_{i=0}^{decimFactor-1} c_{LTP}\right)$$ si les valeurs quantifiées pour la sous-bande sont nulles, ou dans le cas contraire
$c2_{LTP} = c_{LTP}$.

**12.** Programme informatique selon la revendication 7, dans lequel

les données audio codées incluent des données de domaine fréquentiel générées en faisant appel à une ou plusieurs transformées en cosinus discrètes modifiées ;
ladite génération de données décodées inclut la génération de données de domaine temporel à partir des données de domaine fréquentiel au moyen d'une ou plusieurs transformées en cosinus discrètes modifiées inverses ;
les données audio codées incluent des coefficients d'erreur de prédiction ; et
ladite génération de données décodées inclut en outre :

la mise en oeuvre d'une transformée en cosinus discrète modifiée sur des données identifiées modifiées à partir d'une mise en oeuvre précédente de ladite modification des données identifiées ;
la mise à l'échelle des données résultant de ladite mise en oeuvre d'une transformée en cosinus discrète modifiée par un facteur « $c_{LTP}$*upSampFactor », où $c_{LTP}$ représente un coefficient LTP inclus dans le flux reçu au cours de ladite réception d'un flux ; et
l'ajout des données mises à l'échelle à partir de ladite mise à l'échelle des données aux coefficients d'erreur de prédiction.

**13.** Support lisible par une machine incluant un programme informatique selon l'une quelconque des revendications 7 à 12.

**14.** Dispositif, comportant :

un ou plusieurs circuits intégrés (43, 44, 46) configurés de manière à mettre en oeuvre un procédé de traitement de données, le procédé comportant :

la réception (80) d'un flux contenant des données audio codées et des informations prédictives associées aux données audio codées, les informations prédictives ayant été générées sur la base de données dans une mémoire tampon de codage de prédiction à long terme et les informations prédictives incluant une valeur de retard de hauteur tonale ;

la réception (80) d'un facteur indiquant une quantité par laquelle les données audio codées doivent être sur-échantillonnées ou sous-échantillonnées dans le cadre du décodage des données audio codées ;

la génération (81, 82, 83, 84, 102) de données décodées à partir des données audio codées en utilisant le facteur reçu et les informations prédictives ;

la mise en mémoire tampon (102) d'au moins une partie des données décodées dans une ou plusieurs mémoires tampons, au moins une mémoire tampon parmi ladite une ou lesdites plusieurs mémoires tampons présentant au moins une dimension distincte d'une dimension correspondante de la mémoire tampon de codage de prédiction à long terme ;

l'identification (103, 104) d'au moins une partie des données décodées mises en mémoire tampon à utiliser en vue du décodage de données audio codées subséquentes, dans lequel ladite identification d'au moins une partie inclut le calcul d'une valeur de retard de hauteur tonale modifiée ; et

la modification (105) des données identifiées afin qu'elles correspondent à ladite au moins une dimension de mémoire tampon de codage de prédiction à long terme ;

soit dans lequel le facteur reçu au cours de ladite réception d'un facteur indique une quantité par laquelle les données audio codées doivent être sous-échantillonnées et ladite modification des données identifiés inclut l'entrelacement de valeurs nulles entre des éléments des données identifiées ;

soit dans lequel le facteur reçu au cours de ladite réception d'un facteur représente un facteur de sur-échantillonnage, « upSampFactor », ladite mise en mémoire tampon d'au moins une partie inclut la mise en mémoire tampon d'une trame « t » contenant *N*\*upSampFactor échantillons de domaine temporel crénelés, *N* représente la dimension de mémoire tampon de codage de prédiction à long terme correspondante, et ladite mise en mémoire tampon d'au moins une partie inclut en outre la mise en mémoire tampon d'une trame « t - 1 » en transférant chaque upSampFactor^{ième} échantillon d'une trame de domaine temporel totalement reconstituée pour une période de temps récente à la trame « t - 1 ».

**15.** Dispositif selon la revendication 14, dans lequel ledit un ou lesdits plusieurs circuits intégrés constituent un ou plusieurs processeurs.

**16.** Dispositif selon la revendication 14, dans lequel

les données audio codées incluent des données de domaine fréquentiel générées en faisant appel à une ou plusieurs transformées en cosinus discrètes modifiées ; et

ladite génération de données décodées inclut la génération de données de domaine temporel à partir des données de domaine fréquentiel au moyen d'une ou plusieurs transformées en cosinus discrètes modifiées inverses.

**17.** Dispositif selon la revendication 16, dans lequel

le facteur reçu au cours de ladite réception d'un facteur représente un facteur de décimation indicatif d'un sous-échantillonnage ; et

ladite identification d'au moins une partie inclut le calcul de la valeur de retard de hauteur tonale modifiée sur la base de l'équation ci-dessous :

$$lagOffset = \left( ltp\_lag - \left\lfloor \frac{ltp\_lag}{decimFactor} \right\rfloor * decimFactor \right)$$

et

$$lag_d = \left\lfloor \frac{ltp\_lag}{decimFactor} \right\rfloor + lagOffset,$$

où « $lag_d$ » représente la valeur de retard de hauteur tonale modifiée, « $ltp\_lag$ » représente la valeur de retard de hauteur tonale incluse dans les informations prédictives reçues, et « *decimFactor* » représente le facteur de décimation.

**18.** Dispositif selon la revendication 16, dans lequel

les données audio codées incluent des coefficients d'erreur de prédiction ; et
ladite génération de données décodées inclut :

la mise en oeuvre d'une transformée en cosinus discrète modifiée sur des données identifiées modifiées à partir d'une mise en oeuvre précédente de ladite modification des données identifiées ;
la mise à l'échelle des données résultant de ladite mise en oeuvre d'une transformée en cosinus discrète modifiée ; et
l'ajout des données mises à l'échelle à partir de ladite mise à l'échelle des données aux coefficients d'erreur de prédiction.

**19.** Dispositif selon la revendication 18, dans lequel les données audio codées incluent des sous-bandes de fréquence, dans lequel ladite mise à l'échelle des données inclut, pour chaque sous-bande, la mise à l'échelle des données résultant de ladite mise en oeuvre d'une transformée en cosinus discrète modifiée selon l'équation ci-dessous :

$$scale = \begin{cases} c_{LTP} & \text{si decimFactor} = 1 \\ c2_{LT} & \text{sinon} \end{cases}$$

où

« scale » représente un facteur de mise à l'échelle appliqué à des éléments des données provenant de ladite mise en oeuvre d'une transformée en cosinus discrète modifiée ;
« decimFactor » représente le facteur reçu au cours de ladite réception d'un facteur et indicatif d'un sous-échantillonnage ;
$C_{LTP}$ représente un coefficient LTP inclus dans le flux reçu au cours de ladite réception d'un flux ;

$$c2_{LTP} = {}^{MIN\left(1, \prod_{i=0}^{decimFactor-1} c_{LTP}\right)}$$ si les valeurs quantifiées pour la sous-bande sont nulles, ou dans le cas contraire $c2_{LTP} = C_{LTP}$.

**20.** Dispositif selon la revendication 14, dans lequel

les données audio codées incluent des données de domaine fréquentiel générées en faisant appel à une ou plusieurs transformées en cosinus discrètes modifiées ;
ladite génération de données décodées inclut la génération de données de domaine temporel à partir des données de domaine fréquentiel au moyen d'une ou plusieurs transformées en cosinus discrètes modifiées inverses ;
les données audio codées incluent des coefficients d'erreur de prédiction, et
ladite génération de données décodées inclut en outre :

la mise en oeuvre d'une transformée en cosinus discrète modifiée sur des données identifiées modifiées à partir d'une mise en oeuvre précédente de ladite modification des données identifiées ;
la mise à l'échelle des données résultant de ladite mise en oeuvre d'une transformée en cosinus discrète modifiée par un facteur « $c_{LTP}$*upSampFactor », où $c_{LTP}$ représente un coefficient LTP inclus dans le flux reçu au cours de ladite réception d'un flux ; et
l'ajout des données mises à l'échelle à partir de ladite mise à l'échelle des données aux coefficients d'erreur de prédiction.

21. Dispositif selon la revendication 14, dans lequel le dispositif est un dispositif de communication mobile (32).

22. Dispositif selon la revendication 14, dans lequel le dispositif est un ordinateur (34).

23. Dispositif selon la revendication 14, dans lequel le dispositif est un lecteur de musique portable (32).

24. Dispositif selon la revendication 14, comportant :

un moyen (68) pour convertir des échantillons de domaine fréquentiel codant $N$ échantillons de domaine temporel en $N*F$ échantillons de domaine temporel, dans lequel $F$ est un facteur de sur-échantillonnage ou un facteur de sous-échantillonnage ;
un moyen de prédiction (20) ; et
un moyen (69, 70) pour adapter le résultat du moyen de conversion en vue de l'utiliser dans le moyen de prédiction.

25. Dispositif selon la revendication 24, dans lequel

$F$ représente un facteur de sur-échantillonnage ; et
le moyen d'adaptation est configuré de manière à mettre à jour une trame d'une mémoire tampon de prédiction à long terme à chaque $F^{ième}$ échantillon à partir d'une trame de sortie de domaine temporel totalement reconstituées.

26. Dispositif selon la revendication 24, dans lequel

$F$ représente un facteur de sous-échantillonnage, et
le moyen d'adaptation est configuré de manière à étendre $2N*F$ échantillons de domaine temporel dans une partie d'une mémoire tampon à long terme à $2N$ échantillons de domaine temporel.

**FIG. 1A**
Prior Art

**FIG. 1B**
Prior Art

**FIG. 1C**
Prior Art

**FIG. 2**

**FIG. 3**

From
Channel

decimation factor
(decimFactor)

subband flags

15

Bitstream
Demux

Inverse
Quantization

67

IFSS

68

IMDCT

To Synthesis
Filter Bank for
Overlap-Add

16

~ Downsampled
Aliased Time
Domain Signal

21 ~

MDCT

20

Pitch
Predictor

70

Pre-
Processing

LTP
Buffer

~69

pred. coeff., lag

lag

Fully Reconstructed Time
Domain Signal from
Synthesis Filter Bank

**FIG. 4**

LTP Buffer
(decimFactor = 2)

Fully Reconstr. Time
Domain Signal from
Synth. F.B.

Aliased Time
Domain Signal
from IMDCT

max lag

$lag_d$

zero lag

2048

1536

1024

512

| t-2 | t-1 | t | ...0 0 0... |

$X_d$

**FIG. 5**

FIG. 6A

EP 2 022 045 B1

EP 2 022 045 B1

frame t-2          frame t-1          frame t          (all zeros)

LTP Buffer 69
(decimFactor = 2)

$lag_d$ (= 0)

$X_d$

$X_{LTP}$

**FIG. 6B**

FIG. 6C

frame t-2    frame t-1    frame t    (all zeros)

LTP Buffer 69
(decimFactor = 4)

END    START

$lag_d$ (= 0)

$X_d$

$X_{LTP}$

**FIG. 6D**

Start

Receive data stream ⌐80

Extract sub-band flags, prediction information ⌐81

Dequantize coded data ⌐82

Identify sub-bands coded using prediction, sub-bands without prediction ⌐83

Combine prediction and prediction error ⌐84

85
Downsampling? —— Yes —→ A

No

Conventional Processing ⌐86

87
Yes —— More? ←—— B

No

End

**FIG. 7A**

```
        ┌───┐
        │ A │
        └─┬─┘
          ▼
┌─────────────────────┐
│ Shift t-1 frame to t-2 frame, │ ─── 101
│ store most recent fully        │
│ reconstr. sample from syn.     │
│ filt. bank in t-1 frame        │
└─────────────────────┘
          ▼
┌─────────────────────┐
│ Generate aliased time         │ ─── 102
│ domain samples using          │
│ frequency domain data and     │
│ decimation factor; store in t │
│ frame                          │
└─────────────────────┘
          ▼
┌─────────────────────┐
│ Calculate $lag_d$             │ ─── 103
└─────────────────────┘
          ▼
┌─────────────────────┐
│ Identify $X_d$                │ ─── 104
│ (mark START, END)             │
└─────────────────────┘
          ▼
┌─────────────────────┐
│ Generate $X_{LTP}$            │ ─── 105
└─────────────────────┘
          ▼
┌─────────────────────┐
│ MDCT $X_{LTP}[\ ]$            │ ─── 106
│ to obtain $X_{MDCT}[\ ]$      │
└─────────────────────┘
          ▼
        ┌───┐
        │ B │
        └───┘
```

# FIG. 7B

←—1024*upSampFactor samples—→

Fully Reconstructed and
Interpolated Frame in
Synthesis Filter Bank

LTP Buffer
(upSampFactor = 2)

••••

Aliased Time
Domain Signal
from IMDCT

| frame t-2 | ••••••••••••frame t-1•••• | •••••••••••• frame t •••••• | (all zeros) |

←———— 1024 samples ————→ ←——— 1024 samples ———→ ←—1024*upSampFactor samples—→ ←—— 1024 zeros ——→

$X_{LTP}$

max pitch
lag

**FIG. 8A**

EP 2 022 045 B1

LTP Buffer
(upSampFactor = 2)

|← 1024 samples →|← 1024*upSampFactor samples →|

| frame t-2 | frame t-1 | ·············· frame t ······ | (all zeros) |

|← 1024 samples →|

1024 zeros

ltp_lag

| ···················· | ·········· $X_{LTP}$ ··············· | o o ····· o o |

portion corresponding to t-1 frame

portion corresponding to t frame

portion corresponding to all-zero frame

**FIG. 8B**

FIG. 9A

C

Shift t-1 frame to t-2 frame, store every upSampFactor[th] sample from most recent fully reconstr. sample from syn. filt. bank in t-1 frame ⟋~180

Generate aliased time domain samples using frequency domain data and upsampling factor, store in t frame ~182

183

Yes ← Max pitch lag?

No

184 ⟋ $X_{LTP}$ [ ] = t-1 and t-2 frames

Generate $X_{LTP}$ [ ] (include portion of t frame) ~186

MDCT $X_{LTP}$ [ ] to obtain $X_{MDCT}$ [ ] ~187

D

**FIG. 9B**

interpolation factor
(upSampFactor)

From
Channel

subband flags 67'

68'

To Synthesis
Filter Bank for
Overlap-Add

15

Bitstream
Demux → Inverse
Quantization → IFSS → IMDCT

16

~Interpolated
Aliased Time
Domain Signal

20 70'

21~ MDCT ← Pitch
Predictor ← Pre-
Processing ← LTP
Buffer ~69'

pred. coeff., lag lag

Every upSampFactor[th] Sample of
Most Recent Frame of Fully
Reconstructed Time Domain
Signal from Synthesis Filter Bank

**FIG. 10**

interpolation factor (upSampFactor) or
decimation factor (decimFactor)

From
Channel

subband flags 67"

68"

To Synthesis
Filter Bank for
Overlap-Add

15

Bitstream
Demux → Inverse
Quantization → IFSS → IMDCT

16

~ Interpolated or
Downsampled
Aliased Time
Dom. Sig.

20 70"

21~ MDCT ← Pitch
Predictor ← Pre-
Processing ← LTP
Buffer ~69"

pred. coeff., lag lag

Every (or Every upSampFactor[th])
Sample of Most Recent Frame of Fully
Reconstructed Time Domain Signal from
Synthesis Filter Bank

**FIG. 11**

**EP 2 022 045 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1249837 A2